# EUROPEAN PATENT APPLICATION

(11) **EP 2 940 653 A1**
(43) Date of publication of application: **04.11.2015**
(21) Application number: 15164069.5
(22) Date of filing: 17.04.2015
(51) Int. Cl.: G06T 1/00, G06T 7/00

(54) **SYSTEM,APPARATUS AND METHOD,FOR PRODUCING A THREE DIMENSIONAL PRINTED FIGURINE**

(30) Priority: 25.04.2014 US 201414261778
(71) Applicant: Rememborines Inc., Oakville, Ontario L6J 2C9 (CA)
(72) Inventor: Flores Mangas, Fernando, Toronto, Ontario M5R 1L7 (CA); Tracey, Aidan, Oakville, Ontario L6J 2C9 (CA); Forde, Pete, Toronto, Ontario M5T 3A4 (CA)
(74) Representative: Zimmermann, Tankred Klaus

(57) **Abstract**

An apparatus and method for producing a 3D figurine is provided. Images of a subject are received, captured using different cameras. Camera parameters are estimated by processing the images. 3D coordinates representing a surface are estimated by: finding overlapping images which overlap a field of view of a given image; determining a Fundamental Matrix relating geometry of projections of the given image to the overlapping images using the camera parameters; and, for each pixel in the given image, determining whether a match can be found between a given pixel and candidate locations along a corresponding Epipolar line in an overlapping image; when a match is found: estimating respective 3D coordinates of a point associated with positions of both the given pixel and a matched pixel; and adding the respective 3D coordinates to a set. The set is converted to a 3D printer file and sent to a 3D printer.

## Description

### FIELD

The specification relates generally to three dimensional printing, and specifically to a system, apparatus and method, for producing a three dimensional printed figurine.

### BACKGROUND

Automatic and accurate estimation of a three dimensional (3D) model of a volumetric object is used for 3D reproduction of the geometry of the object. 3D models allow visualization, analysis and reproduction of volumetric objects via 3D printing. Data for 3D models can be acquired in two ways: using cameras attached to stands in a studio, the camera and stands arranged in fixed positions around an object in the studio; and using hand-held devices (which can be referred to as "wands") and/or sensors, that are manoeuvred around the object to manually capture its geometry. The studio approach is non-portable. While the wands are portable, they require a human or animal subject to remain static for the entire duration of the scan which occurs over several minutes or longer. If the object being scanned moves, severe undesired shape artefacts are introduced.

### SUMMARY

In general, this disclosure is directed to a system for producing a three dimensional printed figurine, including a mounting rig and/or mounting structure for cameras which is portable, which can include a plurality of ribs which are portable when unassembled and form the mounting rig when assembled. When assembled, the mounting rigs and/or the plurality of ribs define a space therein. The cameras are then attached to the plurality of ribs, the cameras arranged for capturing at least two viewing angles of a substantial portion of a surface of a subject located within the defined space. When a consistency check is to occur at a 3D reconstruction phase, the cameras are arranged for capturing at least three viewing angles of a substantial portion of the surface of the subject. The cameras can optionally be used to also capture background images of the space without a subject in the defined space, and also optionally calibration images of a calibration object placed within the defined space. A computing device receives respective images from the cameras, and the optionally background images and/or the calibration images and transmits them to a server using a communication network, such as the Internet. The server generates a 3D printer file from the respective images and, alternatively, the background images, and, the calibration images, using an efficient method that matches pixels in a given image with locations along Epipolar lines of overlapping images, to estimate the 3D shape of the subject, alternatively ignoring background data.

In general, the mounting rig can be transported from location to location by removing the cameras from the mounting rig, disassembling the mounting rig, and transporting the computing device, the cameras, and the mounting rig to a new location. As the computing device simply coordinates acquisition of images from the cameras and transmits the images to the server, the computing device need not be configured with substantial computing power.

In this specification, elements may be described as "configured to" perform one or more functions or "configured for" such functions. In general, an element that is configured to perform or configured for performing a function is enabled to perform the function, or is suitable for performing the function, or is adapted to perform the function, or is operable to perform the function, or is otherwise capable of performing the function.

It is understood that for the purpose of this specification, language of "at least one of X, Y, and Z" and "one or more of X, Y and Z" can be construed as X only, Y only, Z only, or any combination of two or more items X, Y, and Z (e.g., XYZ, XY, YZ, ZZ, and the like). Similar logic can be applied for two or more items in any occurrence of "at least one ..." and "one or more..." language.

An aspect of the specification provides a system comprising: a mounting rig having an assembled state and an unassembled state, the mounting rig defining a space therein in the assembled state, the mounting rig being portable in the unassembled state; a plurality of cameras attached to the mounting rig in the assembled state, the plurality of cameras arranged for capturing at least two viewing angles of a substantial portion of surface points of a subject located within the space when the mounting rig is in the assembled state, other than those portions of the subject that support the subject; and, a computing device comprising a processor and a communication interface, the computing device in communication with each of the plurality of cameras using the communication interface, the processor configured to: coordinate the plurality of cameras to capture respective image data at substantially a same time; receive a plurality of images comprising the respective image data from the plurality of cameras; and, transmit, using the communication interface, the plurality of images to a server for processing into a three dimensional (3D) printer file.

The mounting rig can comprise a plurality of ribs that are assembled in the assembled state of the mounting rig, and unassembled in the unassembled state of the mounting rig.

The system can further comprise a pedestal configured to support the subject, the pedestal located within the space when the mounting rig is in the assembled state.

The system can further comprise a calibration device that can be placed within the space prior to capturing images of the subject, the calibration device comprising calibration patterns that can be captured by the plurality of cameras, the processor further configured to: control the plurality of cameras to capture calibration data comprising images of the calibration device; and transmit, using the communication interface, the calibration data to the server for use by the server in generating the 3D printer file. The calibration device can comprise one or more of a cube, a hexahedron, a parallelepiped, a cuboid and a rhombohedron, and a three-dimensional solid object, each face of the calibration device comprising a different calibration pattern

The processor can be further configured to: control the plurality of cameras to capture background image data comprising images of the space without the subject; and, transmit, using the communication interface, the background image data to the server for use by the server in generating the 3D printer file.

The processor can be further configured to generate metadata identifying a time period in which the respective images were acquired so that the respective images can be coordinated with one or more of calibration data and background data.

The system can further comprise one or more of background objects, background curtains and background flats. The background objects can be attachable to the mounting rig in the assembled state. The system can further comprise a frame configured to at least partially encircle the mounting rig in the assembled state, wherein the background objects are attachable the frame.

The plurality of cameras attached to the mounting rig in the assembled state can be arranged to capture at least three viewing angles of the substantial portion of surface points of a subject located within the space when the mounting rig is in the assembled state, other than those portions of the subject that support the subject.

The system can further comprise one or more of fasteners and tools for assembling the mounting rig to the assembled state from the unassembled state.

Another aspect of the specification provides a method comprising: at a server comprising a processor and a communication interface, receiving, using the communication interface, a plurality of images of a subject, each of the plurality of images captured using a different camera of a plurality of cameras; estimating, using the processor, one or more camera parameters of each of the plurality of cameras by processing the plurality of images; estimating, using the processor, three-dimensional (3D) coordinates of 3D points representing a surface of the subject by, for each of the plurality of images: finding a subset of overlapping images, of the plurality of images, which overlap a field of view of a given image; determining a Fundamental Matrix that relates geometry of projections of the given image to each of the overlapping images using the one or more camera parameters; for each pixel in the given image, determining whether a match can be found between a given pixel and a plurality of candidate locations along a corresponding Epipolar line in an overlapping image and, when a match is found: estimating respective 3D coordinates of a point associated with both a position of the given pixel and a respective position of a matched pixel; and adding the respective 3D coordinates to a set of the 3D points; converting, using the processor, the set of the 3D points to a 3D printer file; and, transmitting, using the communication interface, the 3D printer file to a 3D printer for 3D printing of a figurine representing the subject.

The method can further comprise: masking, using the processor, pixels representative of a background of the subject in the plurality of images to determine a foreground that can comprise a representation of the subject; and, when the masking occurs, then the determining whether a match can be found between a given pixel and a plurality of candidate locations along a corresponding Epipolar line in an overlapping image occurs for each pixel in the given image that is associated with the foreground, and the pixels representative of the background are ignored.

Estimating of the one or more camera parameters of each of the plurality of cameras by processing the plurality of images can occur using Bundle Adjustment.

The camera parameters can comprise respective representations of radial distortion for each of the plurality of cameras, the method can further comprise correcting, using the processor, one or more types of image distortion in the plurality of images using the respective representations of the radial distortion, prior to the masking.

The one more camera parameters can comprise the respective positions and respective orientations of: a camera used to acquire the given image; and respective cameras used to acquire the overlapping images; and the determining the Fundamental Matrix can comprise using the respective positions and the respective orientations to determine the Fundamental Matrix.

The method can further comprise: checking consistency of the set, keeping a given 3D point when multiple images produce a consistent 3D coordinate estimate of the given 3D point, and discarding the given 3D point when the multiple images produce inconsistent 3D coordinates.

The converting the set of the 3D points to a 3D printer file can comprise: determining a polygonal relation between the set of the 3D points; and estimating surface normals thereof.

Yet a further aspect of the specification provides a server comprising: a processor and a communication interface, the processor configured to: receive a plurality of images of a subject, each of the plurality of images captured using a different camera of a plurality of cameras; estimate one or more camera parameters of each of the plurality of cameras by processing the plurality of images; estimate three-dimensional (3D) coordinates of 3D points representing a surface of the subject by, for each of the plurality of images: finding a subset of overlapping images, of the plurality of images, which overlap a field of view of a given image; determining a Fundamental Matrix that relates geometry of projections of the given image to each of the overlapping images using the one or more camera parameters; for each pixel in the given image, determine whether a match can be found between a given pixel and a plurality of candidate locations along a corresponding Epipolar line in an overlapping image and, when a match is found: estimating respective 3D coordinates of a point associated with both a position of a given pixel and a respective position of a matched pixel; and adding the respective 3D coordinates to a set of the 3D points; convert the set of the 3D points to a 3D printer file; and, transmit the 3D printer file to a 3D printer for 3D printing of a figurine representing the subject.

Yet another aspect of the present specification provides a computer program product, comprising a computer usable medium having a computer readable program code adapted to be executed to implement a method comprising: at a server comprising a processor and a communication interface, receiving, using the communication interface, a plurality of images of a subject, each of the plurality of images captured using a different camera of a plurality of cameras; estimating, using the processor, one or more camera parameters of each of the plurality of cameras by processing the plurality of images; estimating, using the processor, three-dimensional (3D) coordinates of 3D points representing a surface of the subject by, for each of the plurality of images: finding a subset of overlapping images, of the plurality of images, which overlap a field of view of a given image; determining a Fundamental Matrix that relates geometry of projections of the given image to each of the overlapping images using the one or more camera parameters; and, for each pixel in the given image, determine whether a match can be found between a given pixel and a plurality of candidate locations along a corresponding Epipolar line in an overlapping image and, when a match is found: estimating respective 3D coordinates of a point associated with both a position of a given pixel and a respective position of a matched pixel; and adding the respective 3D coordinates to a set of the 3D points; converting, using the processor, the set of the 3D points to a 3D printer file; and, transmitting, using the communication interface, the 3D printer file to a 3D printer for 3D printing of a figurine representing the subject.

Yet another aspect of the present specification provides a system comprising: a mounting rig having an assembled state and an unassembled state, the mounting rig defining a space therein in the assembled state, the mounting rig being portable in the unassembled state; a plurality of cameras attached to the mounting rig in the assembled state, the plurality of cameras arranged for capturing at least two viewing angles of a substantial portion of surface points of a subject located within the space when the mounting rig is in the assembled state, other than those portions of the subject that support the subject; and, a computing device comprising a processor and a communication interface, the computing device in communication with each of the plurality of cameras using the communication interface, the processor configured to: coordinate the plurality of cameras to capture respective image data at substantially a same time; receive a plurality of images comprising the respective image data from the plurality of cameras; and, transmit, using the communication interface, the plurality of images to a server for processing into a three dimensional (3D) printer file.

### BRIEF DESCRIPTIONS OF THE DRAWINGS

For a better understanding of the various implementations described herein and to show more clearly how they may be carried into effect, reference will now be made, by way of example only, to the accompanying drawings in which:
Fig. 1 depicts a system for producing a three dimensional printed figurine, according to non-limiting implementations.
Fig. 2 depicts a portable system for capturing for producing a three dimensional printed figurine, in an unassembled state, according to non-limiting implementations.
Fig. 3 depicts assembly of a portion of ribs of a mounting rig, according to non-limiting implementations.
Fig. 4 depicts attachment of cameras to a rib of the system of Fig. 2, according to non-limiting implementations.
Fig. 5 depicts the system of Fig. 2 in an assembled state, and being used in a calibration process, according to non-limiting implementations.
Fig. 6 depicts the system of Fig. 2 in an assembled state, and being used in an image capture process, according to non-limiting implementations.
Fig. 7 depicts the system of Fig. 1, being used in a data transfer process between a computing device and a server, according to non-limiting implementations.
Fig. 8 depicts a mounting rig with optional lights attached thereto, according to non-limiting implementations.

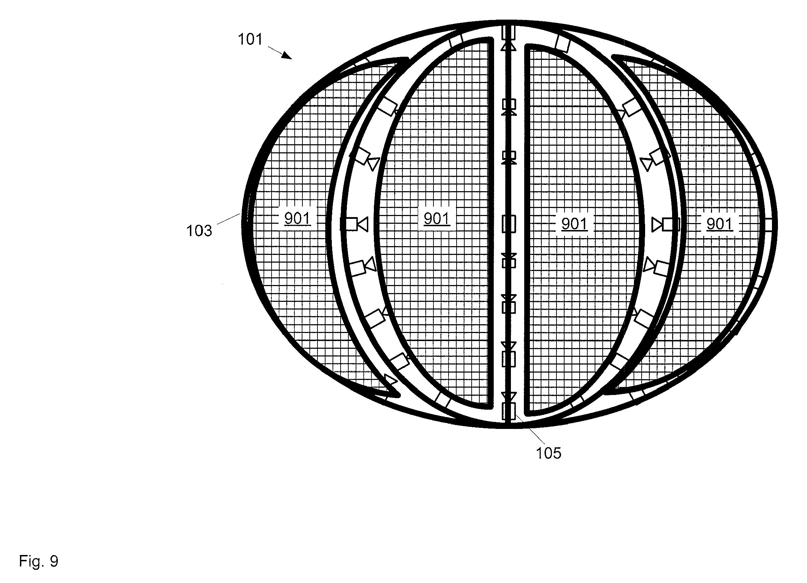

Fig. 9 depicts a mounting rig with background objects attached thereto, according to non-limiting implementations.
Fig. 10 depicts a method for acquiring images for producing a 3D figurine, according to non-limiting implementations.
Fig. 11 depicts a method for producing a 3D printer file, according to non-limiting implementations.
Fig. 12 depicts a method of estimating 3D coordinates, according to non-limiting implementations.
Fig. 13 depicts aspects of the method of Fig. 12, according to non-limiting implementations.
Fig. 14 depicts the system of Fig. 1, being used in a 3D printer file transfer process between the server and a 3D printer, according to non-limiting implementations.

### DETAILED DESCRIPTION

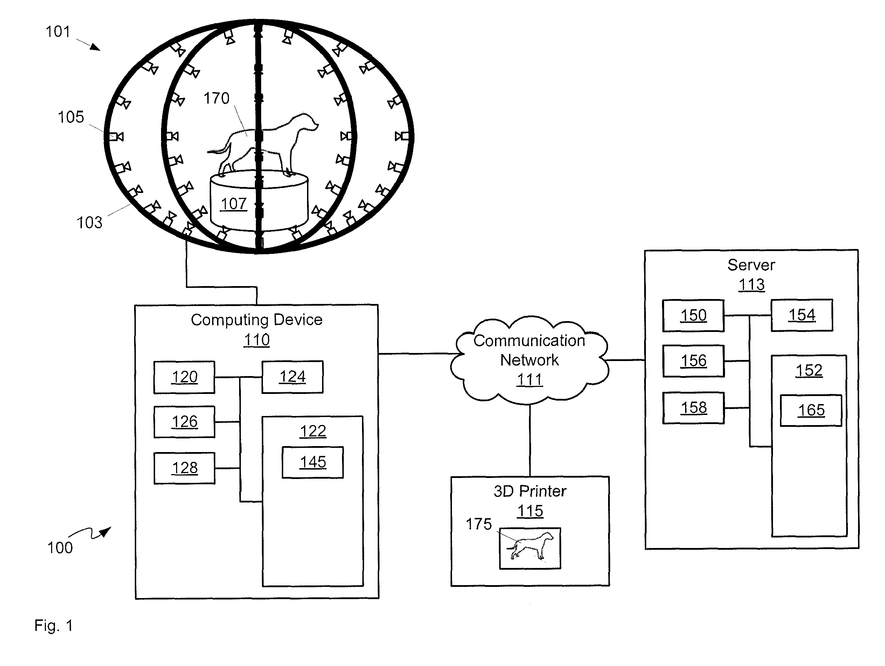

Fig. 1 depicts a system 100 for producing a three dimensional (3D) printed figurine, according to non-limiting implementations. System 100 comprises: a portable mounting rig 101 which, as depicted, comprises a plurality of ribs 103; a plurality of cameras 105 attached to mounting rig 101, an optional pedestal 107 located within mounting rig 101, a computing device 110 (interchangeably referred to hereafter as device 110) in communication with the plurality of cameras 105, a communication network 111 (interchangeably referred to hereafter as network 111), a server 113 and a 3D printer 115. While Fig. 1 depicts a plurality of ribs 103 and a plurality of ribs of cameras 105, only one of each is labelled for clarity. Device 110 generally comprises a processor 120 interconnected with a memory 122, a communication interface 124 (interchangeably referred to hereafter as interface 124), a display 126, and at least one input device 128. Plurality of ribs 103 will be interchangeably referred to hereafter, collectively, as ribs 103, and generically as a rib 103; similarly, plurality of cameras 105 will be interchangeably referred to hereafter, collectively, as cameras 105, and generically as a camera 105. Mounting rig 101 can further be interchangeably referred to a mounting structure.

Memory 122 generally stores an application 145 that, when processed by processor 120, causes processor 120 to acquire images from the plurality of cameras 105, and transmit the images to server 113 via network 111, as described in more detail below. Server 113 generally comprises a processor 150 interconnected with a memory 152, a communication interface 154 (interchangeably referred to hereafter as interface 154), and, optionally, a display 156, and at least one input device 158. Memory 152 generally stores an application 165 that, when processed by processor 150, causes processor 150 to generate a 3D printer file from the images received from device 110, and transmit the 3D printer file to 3D printer 115, via network 111, as described in more detail below.

Also depicted in Fig. 1 are a subject 170 (as depicted, a dog) and a figurine 175 of subject 170 produced by 3D printer 115. While subject 170 is depicted as a dog, subjects can comprise other types of animals, children, adults, plants, and inanimate objects.

In general, mounting rig 101 is portable and can be assembled and disassembled at a location where images of a many subjects can be acquired, for example a dog show, a school on "picture" day, and the like. A subject is placed and/or positions themselves within the space defined by mounting rig 101 and/or optionally on pedestal 107 (as depicted), and images of the subject are acquired by cameras 105, which are arranged to capture at least two viewing angles of a substantial portion of surface points of the subject within the space defined by mounting rig 101, which will interchangeably be referred hereafter as the defined space. In some instances, when a consistency check is to occur at a 3D reconstruction phase, cameras 105 are arranged to capture at least three viewing angles of a substantial portion of surface points of a subject, as described in further detail below.

Cameras 105 can acquire a plurality of images of a subject, for example in a coordinated synchronous mode, as controlled by computing device 110, and the subject and/or a user paying for acquisition of the images, reviews set of images that were synchronously acquired, and/or one or more representative images from each set of images at display 126, to select a pose of the subject as acquired by cameras 105. In other words, cameras 105 can each operate in a coordinated burst mode to periodically acquire sets of images, each set of images comprising images acquired within a common given time period. The plurality of images corresponding to a selected set of images is then transmitted to server 113 and a 3D printer file is generated, as described below, which is then transmitted to 3D printer 115, where figurine 175 is produced, packaged and provided (e.g. mailed) to the user. A set of images that were synchronously acquired as referred to herein described a set of images 603 that were acquired by cameras 105 within a given time period.

Each camera 105 can comprise one or more of a digital camera, a CCD (charge-coupled device), and the like, each having a resolution suitable for producing figurine 175. For example, in non-limiting implementations, each camera 105 can have a resolution of at least 3 MP (megapixels), though it is appreciated that higher megapixel counts can provide better detail for figurine 175. In general about 5 MP resolution for each camera can provide detail for producing figurine 175. Furthermore, each camera 105 comprises a communication interface for wired and/or wireless communication with device 110.

Optional dedestal 107 comprises a pedestal for supporting subject 170 and optionally for raising a centre of subject towards a centre of mounting rig 101. As depicted, pedestal 107 comprises a cylinder suitable for supporting a dog, however in other implementations, pedestal 107 can comprise a box, a cube or any other geometric shape. In yet further implementations, pedestal can comprise actuators, hydraulics and the like for raising and lowering subject 175 within mounting rig 101. In some implementations, depending on locations of cameras 105, and a shape of a subject being photographed, pedestal 107 can be optional. In other words, a subset of cameras 105 can be located "low enough" on mounting rig 101, in the assembled state, to capture images of a subject's feet, other than the regions in contact with the ground.

It is appreciated that Fig. 1 also depicts a schematic diagram of device 110, which can include, but is not limited to, any suitable combination of electronic devices, communications devices, computing devices, personal computers, servers, laptop computers, portable electronic devices, mobile computing devices, portable computing devices, tablet computing devices, laptop computing devices, internet-enabled appliances and the like. Other suitable devices are within the scope of present implementations.

It should be emphasized that the structure of computing device 110 in Fig. 1 is purely an example, and contemplates a device that can be used for communicating with cameras 105 and server 113. However, Fig. 1 contemplates a device that can be used for any suitable specialized functions, including, but not limited, to one or more of, computing functions, mobile computing functions, image processing functions, electronic commerce functions and the like.

Processor 120 can be implemented as a plurality of processors, including but not limited to one or more central processors (CPUs). Processor 120 is configured to communicate with a memory 122 comprising a non-volatile storage unit (e.g. Erasable Electronic Programmable Read Only Memory ("EEPROM"), Flash Memory) and a volatile storage unit (e.g. random access memory ("RAM")). Programming instructions that implement the functional teachings of computing device 110 as described herein are typically maintained, persistently, in memory 122 and used by processor 120 which makes appropriate utilization of volatile storage during the execution of such programming instructions. Those skilled in the art will now recognize that memory 122 is an example of computer readable media that can store programming instructions executable on processor 120. Furthermore, memory 122 is also an example of a memory unit and/or memory module.

Memory 122 further stores an application 145 that, when processed by processor 120, enables processor 120 to communicate with cameras 105 and server 113. Processing of application 145 can optionally enable processor 120 to provide electronic commerce functionality at device 110; for example device 110 can be used to process electronic payment for production and delivery of figurine 175. Furthermore, memory 122 storing application 145 is an example of a computer program product, comprising a non-transitory computer usable medium having a computer readable program code adapted to be executed to implement a method, for example a method stored in application 145.

Processor 120 also connects to interface 124, which can be implemented as one or more radios and/or connectors and/or network adaptors and/or transceivers, configured to communicate with cameras 105 and server 113 via one or more wired and/or wireless communication links there between. It will be appreciated that interface 124 is configured to correspond with communication architecture that is used to implement one or more communication links with cameras 105, network 111, and server 113, including but not limited to any suitable combination of, cables, serial cables, USB (universal serial bus) cables, and wireless links (including, but not limited to, WLAN (wireless local area network) links, WiFi links, WiMax links, cell-phone links, Bluetooth links, NFC (near field communication) links, packet based links, the Internet, analog networks, access points, and the like, and/or a combination).

Display 126 comprises any suitable one of, or combination of, flat panel displays (e.g. LCD (liquid crystal display), plasma displays, OLED (organic light emitting diode) displays, capacitive or resistive touchscreens, CRTs (cathode ray tubes) and the like).

At least one input device 128 generally configured to receive input data, and can comprise any suitable combination of input devices, including but not limited to a keyboard, a keypad, a pointing device, a mouse, a track wheel, a trackball, a touchpad, a touch screen and the like. Other suitable input devices are within the scope of present implementations.

While not depicted, device 110 further comprises a power source, for example a connection to a mains power supply and a power adaptor (e.g. and AC-to-DC (alternating current to direct current) adaptor, and the like).

In any event, it should be understood that a wide variety of configurations for computing device 110 are contemplated. For example, in some implementations, display 126 and at least one input device 128 can be integrated device 110 (as depicted), while in other implementations, one or more of display 126 and at least one input device 128 can be external to device 110.

Network 111 can comprise any suitable combination of communication networks, including, but not limited to, wired networks, wireless networks, WLAN networks, WiFi networks, WiMax networks, cell-phone networks, Bluetooth networks, NFC (networks, packet based networks, the Internet, analog networks, access points, and the like, and/or a combination.

It is appreciated that Fig. 1 also depicts a schematic diagram of server 113, which can include, but is not limited to, any suitable combination of servers, communications devices, computing devices, personal computers, laptop computers, laptop computing devices, internet-enabled appliances and the like. Other suitable devices are within the scope of present implementations.

Server 113 can be based on any well-known server environment including a module that houses one or more central processing units, volatile memory (e.g. random access memory), persistent memory (e.g. hard disk devices) and network interfaces to allow server 113 to communicate over a link to communication network 111. For example, server 113 can be a Sun Fire V480 running a UNIX operating system, from Sun Microsystems, Inc. of Palo Alto Calif., and having four central processing units each operating at about nine-hundred megahertz and having about sixteen gigabytes of random access memory. However, it is to be emphasized that this particular server is merely exemplary, and a vast array of other types of computing environments for server 113 are contemplated. It is further more appreciated that server 113 can comprise any suitable number of servers that can perform different functionality of server implementations described herein.

It should be emphasized that the structure of server 113 in Fig. 1 is purely an example, and contemplates a server that can be used for communicating with device 110 and 3D printer 115. However, Fig. 1 contemplates a device that can be used for any suitable specialized functions, including, but not limited, to one or more of, computing functions, image processing functions and the like.

Processor 150 can be implemented as a plurality of processors, including but not limited to one or more central processors (CPUs). Processor 150 is configured to communicate with a memory 152 comprising a non-volatile storage unit (e.g. Erasable Electronic Programmable Read Only Memory ("EEPROM"), Flash Memory) and a volatile storage unit (e.g. random access memory ("RAM")). Programming instructions that implement the functional teachings of server 113 as described herein are typically maintained, persistently, in memory 152 and used by processor 150 which makes appropriate utilization of volatile storage during the execution of such programming instructions. Those skilled in the art will now recognize that memory 152 is an example of computer readable media that can store programming instructions executable on processor 150. Furthermore, memory 152 is also an example of a memory unit and/or memory module.

Memory 152 further stores an application 165 that, when processed by processor 150, enables processor 150 to communicate with device 110 and 3D printer 115, and to produce a 3D printer file from images received from device 110. Furthermore, memory 152 storing application 165 is an example of a computer program product, comprising a non-transitory computer usable medium having a computer readable program code adapted to be executed to implement a method, for example a method stored in application 165.

Processor 150 also connects to interface 154, which can be implemented as one or more radios and/or connectors and/or network adaptors and/or transceivers, configured to communicate with cameras 105 and server 113 via one or more wired and/or wireless communication links there between. It will be appreciated that interface 154 is configured to correspond with communication architecture that is used to implement one or more communication links with cameras 105, network 111, and server 113, including but not limited to any suitable combination of, cables, serial cables, USB (universal serial bus) cables, and wireless links (including, but not limited to, WLAN (wireless local area network) links, WiFi links, WiMax links, cell-phone links, Bluetooth links, NFC (near field communication) links, packet based links, the Internet, analog networks, access points, and the like, and/or a combination).

Optional display 156 and optional input device 158 can be respectively similar to display 126 and at least one input device 128.

While not depicted, server 113 further comprises a power source, for example a connection to a main power supply and a power adaptor (e.g. and AC-to-DC (alternating current to direct current) adaptor, and the like).

In any event, it should be understood that a wide variety of configurations for server 113 are contemplated.

3D printer 115 can comprise any 3D printer suitable for producing figurine 175 from a 3D printer file. While not depicted, it is appreciated that 3D printer 115 can be in communication with network 111 via an intermediate computing device; alternatively, 3D printer 115 is not in communication with network 111; rather, the intermediate computing device can be in communication with network 111 and/or server 113, and a 3D printer file is transmitted to the intermediate computing device, the 3D printer file being manually transferred to 3D printer 115 for 3D printing of figurine 175. Hence, transmission of a 3D printer file to 3D printer can include, but is not limited to, such implementations.

Each of device 110, server 113 and 3D printer 115 can be operated by different entities and/or businesses and/or companies. For example, an entity operating server 113 can provide one or more other entities with elements of system 200 including, but not limited to, mounting rig 101, cameras 105, etc., and/or software (e.g. application 145) for use with device 110 for acquiring images of subjects to be 3D printed as 3D figurine 175. Indeed, system 100 can include a plurality of systems 200, each being operated at and/or transported to different geographic locations by different entities and/or the same entity. The entity operating server 113 can receive images to be processed into 3D printer files from a plurality of system 200, process the images into 3D printer files, select one or more 3D printer companies, operating 3D printers, including 3D printer 115, and transmit the 3D printer files thereto for 3D printing of figures, including figurine 175. In this manner, the entity operating server 113 can act as a central manager of image collection and 3D printing without having to collect images and/or operate 3D printer 115. Further, images for processing into 3D printer files can be acquired at many different geographic locations simultaneously, through deployment of a plurality of systems 200, and different 3D printer companies/entities can be used to print figurines.

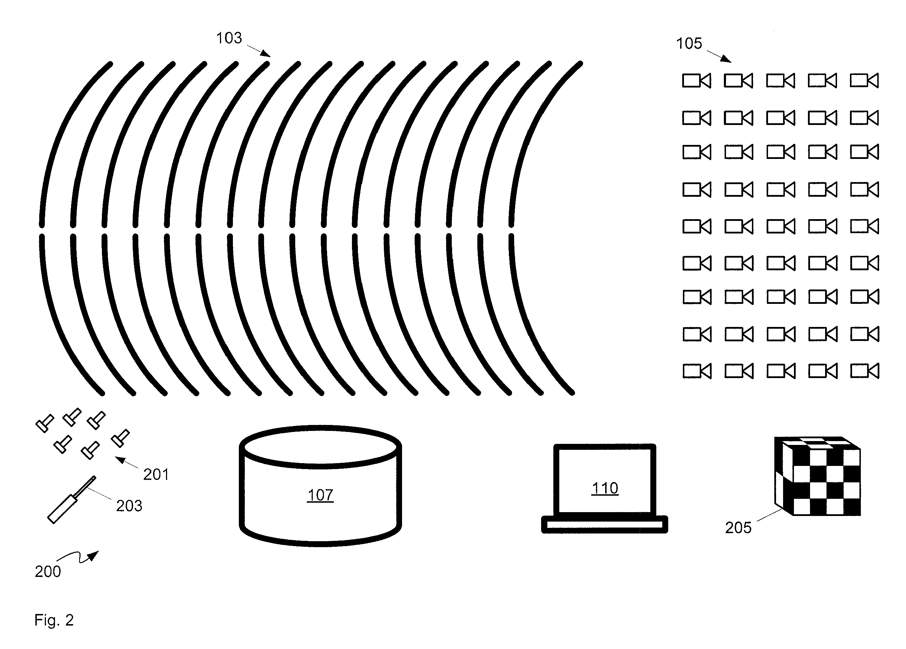

Attention is next directed to Fig. 2 which depicts a non-limiting example of a portable system 200 which can be transported from location to location to acquire images of a subject for processing into a 3D printer file. System 200 comprises: ribs 103, in an unassembled state, cameras 105, optional pedestal 107, and computing device 110. As depicted, system 200 further comprises fasteners 201 and one or more tools 203 for assembling ribs 103 to the assembled state from the unassembled state. As depicted system 200 further comprises an optional calibration device 205 that can be placed within the defined space, and/or optionally on pedestal 107, prior to capturing images of the subject, calibration device 205 comprising calibration patterns that can be captured by plurality of cameras 105, for example during a calibration step.

As depicted, calibration device 205 comprises one or more of a cube, a hexahedron, a parallelepiped, a cuboid, a rhombohedron, and a three-dimensional solid object, each face of calibration device 205 comprising a different calibration pattern, including, but not limited to, a different checkerboard board patterns (e.g. as depicted checkerboard patterns of different checkerboard densities, 2x2, 3x3, 4x4, etc.; while only three calibration patterns are depicted, as only three sides of calibration device 205 are visible in Fig. 2, other faces of calibration device 205 also comprise calibration patterns, though a calibration pattern on a bottom face can be optional).

Fig. 2 depicts system 200 in an unassembled state; for example, ribs 103 are depicted in an unassembled state for transportation from location to location, and cameras 105 are depicted as being unattached to ribs 103. In other words, in depicted implementations, mounting rig 101 comprises plurality of ribs 103 that are assembled in the assembled state of mounting rig 101, and unassembled in the unassembled state of mounting rig 101, the unassembled state depicted in Fig. 2.While not depicted, system 200 can further comprise cables and the like for connecting computing device 110 to cameras 105, though, in some implementations, communication there between can be wireless.

While not depicted, system 200 can comprise containers, boxes and the like for transporting ribs 103, cameras 105 etc.; such containers can include, but are not limited to, padded boxes, foam lined boxes, and the like.

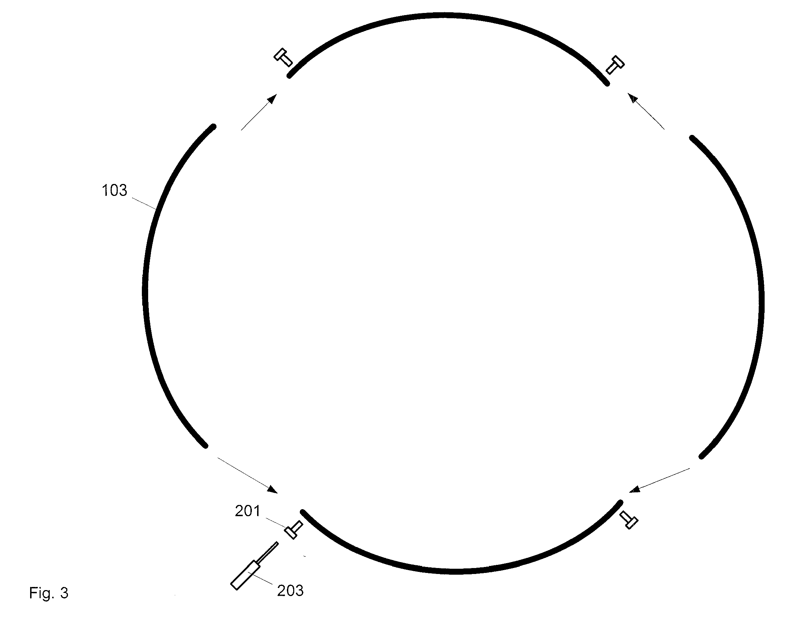

Attention is next directed to Fig. 3, which depicts a non-limiting example of assembly of a portion of ribs 103: while not depicted, in the depicted example, ends of each rib 103 are configured to mate with a corresponding end of another rib 103, and the two ends can be optionally fastened together with fasteners 201 and/or tool 203. Alternatively, ends of each rib 103 can be configured to both mate and interlock with a corresponding end of another rib 103, so that fasteners 201 and/or tool 203 are optional and/or are not used in the assembly. For example, ends of ribs 103 can comprise interlocking bayonet style mounts, and the like. Ribs 103 are assembled into a larger rib 103, and such larger ribs 103 can be assembled into mounting rig 101 to form an ellipsoid and/or cage structure shown in Fig. 1. Alternatively, mounting rig 101 can include a top portion and a bottom portion into which a plurality of ribs 103 can be removabley inserted to form the ellipsoid and/or cage structure.

While unassembled ribs 103 are depicted as curved, in other implementations, ribs 103 can be straight and connectable so that an assembled rib 103 is substantially curved (e.g. straight pieces joined at angles).

Ribs 103 can include, but are not limited to, tubes, pipes and the like. In some implementations, ribs 103 can be formed from metal, including but not limited to aluminum, while in other implementations, ribs 103 can be formed from plastic. Ribs 103 can be inflexible and/or flexible; in implementations where a portion of ribs 103 are flexible, ribs 103 can be held in place with supporting structures and/or inflexible supporting ribs 103. In yet further implementations, ribs 103 can include vertical ribs and/or horizontal ribs that define a space therein that is generally ellipsoidal, and/or are arranged so that cameras 105 can be attached thereto so that cameras 105 are arranged in a generally ellipsoidal pattern.

In yet a further alternative, in the unassembled state, ribs 103 can be connected, but folded together to form a substantially flat and/or a comparatively smaller structure than mounting rig 101; then, in the assembled state, ribs 103 can be unfolded to form mounting rig 101. Hence, the term "unassembled" can include an unhinged and/or folded state of ribs 103; in other words, ribs 103 need not be physically taken apart, and/or separated from each other to be unassembled.

Furthermore, while in the assembled state, mounting rig 101 in Fig. 1 comprises ribs 103 radiating outward from a top and then back in towards a bottom (e.g. longitudinally), to form the ellipsoid and/or cage structure, in other implementations, mounting rig 101 can comprise ribs 103 that attach to and encircle other ribs 103 (e.g. latitudinally) to provide stability to mounting rig 101. In yet further implementations, ribs 103 in the assembled state can be substantially latitudinal, held together using longitudinal ribs.

While Fig. 2 depicts 32 ribs 103, any suitable number of ribs 103 for forming mounting rig 101 is within the scope of present implementations; for example, as depicted in Fig. 3, four ribs 103 are assembled into a larger rib 103, however, in other implementations more or fewer than four ribs 103 are assembled into a larger rib 103.

In yet further implementations, mounting rig 101 can comprise other types of geometries, for example ellipsoidal geodesic dome structures, and the like.

Mounting rig 101 can further comprise pieces that are not ribs, including, but not limited to substantially flat pieces that interlock together, and to which cameras 105 can be attached, for example using interlocking structures at cameras 105 and mounting rig 101. Indeed, in yet further implementations, mounting rig 101 does not comprise ribs, but comprises interlocking pieces and/or folding pieces, and the like, to which cameras 105 can be mounted.

Furthermore, in general, mounting rig 101 and/or ribs 103 in the assembled state allow for a subject to enter and leave the space defined by mounting rig 101 and/or ribs 103. For example, as in Fig. 1 a space between ribs 103 is such that a user can enter and/or leave an interior of mounting rig 101 and/or ribs 103.

Returning to Fig. 2, while 45 cameras 105 are depicted, any suitable number of cameras 105 for capturing at least two viewing angles of a substantial portion of surface points of a subject located within the space defined by mounting rig 101 (and/or located on pedestal 107) is within the scope of present implementations; for example, a number of cameras can be as few as about 20 and as many as about 100 or more. However, between about 30 to about 50 cameras 105 can generally capture at least two viewing angles of a substantial portion of surface points of subject 170. In yet further implementations a number of cameras 105 can be chosen for capturing at least three viewing angles of a substantial portion of surface points of a subject.

In any event, it should be appreciated that a wide variety of configurations for mounting rig 101 and/or ribs 103 are contemplated, as longs as mounting rig 101 and/or ribs 103 are portable in the unassembled state. Such portability can include mounting rig 101 and/or ribs 103 being transportable using a vehicle such as a car, a minivan an SUV and the like. Furthermore, while as depicted herein, mounting rig 101 comprises ribs 103 arranged in longitudinally in an ellipsoidal and/or cage structure, in other implementations ribs 103 can be assembled into other arrangements and/or patterns, for example diagonal patterns, criss-cross patterns and the like. Furthermore, while a bottom and top of depicted assembled states of ribs 103 are shown as closed (i.e. ribs 103 join at the top and bottom), in other implementations one or more of a bottom and top of ribs 103 in the assembled state can be open (e.g. a top and/or a bottom can comprise an open ring structure into which ribs 103 are inserted and/or are joined); in yet further implementations mounting rig 101 can further comprise a base that can be joined to ribs 103 to provide stability to ribs 103 in the assembled state.

While in depicted implementations, the ellipsoid formed by mounting rig 101 and/or ribs 103 in the assembled state has a longitudinal axis that is about parallel to the ground (e.g. between left and right in Fig. 1) in other implementations, a longitudinal axis of the ellipsoid can be about perpendicular to the ground (e.g. up and down). For example, when a body of a subject is generally parallel to the ground, as with dogs, the ellipsoid formed by mounting rig 101 and/or ribs 103 can have a longitudinal axis that is about parallel to the ground; similarly, when a body of a subject is generally perpendicular to the ground, as with humans, the ellipsoid formed by mounting rig 101 and/or ribs 103 can have a longitudinal axis that is about perpendicular to the ground. In some implementations, a position of the longitudinal axis of the ellipsoid can be configurable during assembly of mounting rig 101 and/or ribs 103; in yet other implementations, a position of the longitudinal axis of the ellipsoid can be configurable after assembly of mounting rig 101 and/or ribs 103 (e.g. a configuration of mounting rig 101 can be changed between two configurations); in yet further implementations, a position of the longitudinal axis of the ellipsoid is fixed for a given set of ribs 103 and/or a given type of mounting rig 101, and different sets of ribs 103 and/or a different type of mounting rig 101 can be used for a given subject type, for example a mounting rig 101 and/or ribs 103 that assembles into an ellipsoid having a longitudinal axis that is about parallel to the ground, and another mounting rig 101 and/or ribs 103 that assembles into an ellipsoid having a longitudinal axis that is about perpendicular to the ground.

In other words, as it can be desirable to keep an about constant distance from a surface of a subject to cameras 105, mounting rig 101 can resemble a 3D ellipsoid. When a subject is elongated mounting rig 101 can accommodate a deformation that matches an elongation of the subject.

The nature of the subject, for example dogs children or adults, can further assist in defining dimensions of the ellipsoid and/or mounting rig 101 and/or ribs 103 in the assembled state. For example, when dogs are to be the primary subject, mounting rig 101 in the assembled state, can have a height of about 6 feet and a longitudinal length of about 7 feet; when children are to be the primary subject, mounting rig 101 in the assembled state, can have a height of about 7 feet and a longitudinal length of about 6 feet; when adults are to be the primary subject, mounting rig 101 in the assembled state, can have a height of about 8 feet and a longitudinal length of about 6 feet. However, the exact dimensions of the ellipsoid and/or mounting rig 101 and/or ribs 103 in the assembled state can vary, and other dimensions are within the scope of present implementations.

In yet further implementations, each rib 103 can have a predetermined position in the assembled state. For example, in some of these implementations, each rib 103 and/or ends of ribs 103, can be numbered so that given ribs 103 are attached to other given ribs 103 in the assembled state, and such assembly results in each rib 103 being located in the same relative position each time assembly occurs; in other implementations, a given end of a rib 103 can be configured to mate with a corresponding end of one other given rib 103 so that there is one way of assembling ribs 103.

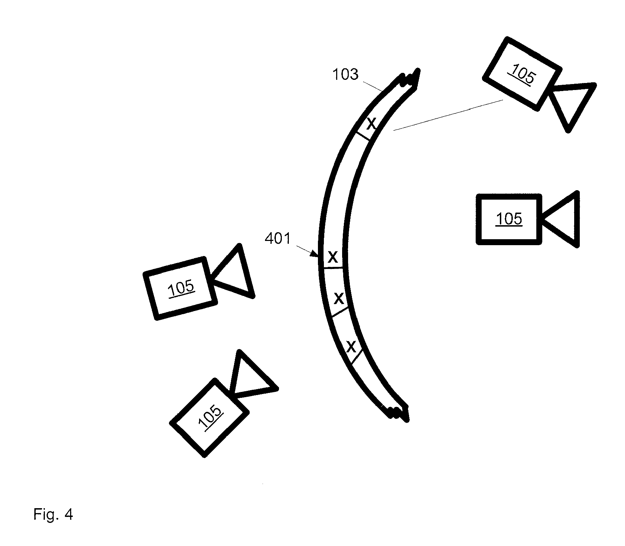

Attention is next directed to Fig. 4, which depicts a non-limiting example of a subset of cameras 105 being attached to an example rib 103. In these implementations, it is appreciated that each rib 103 has been assembled in a given position, as each rib 103 comprises indications 401 of one or more of: a respective mounting position of a camera 105 and a respective orientation and/or angle for mounting a camera 105 at a mounting position. As depicted, indications 401 are printed on ribs 103. For example, as depicted, each of indications 401 comprises a mark "X", where a camera 105 is to be mounted, and a line showing an orientation and/or angle at which a camera 105 is to be mounted. Hence, when cameras 105 are being mounted to ribs 103, a body of a given camera 105 can be aligned with a respective line at a position marked by an "X". It is further appreciated that during such assembly the alignments is to occur so that a lens of each camera 105 is facing towards a space defined by ribs 103 in the assembled state (e.g. inwards and/or towards pedestal 107, as depicted in Fig. 1). Other indications are within the scope of present implementations; for example, a line showing orientation and/or angle without a mark "X".

While not depicted, one or more of ribs 103 and cameras 105 comprise equipment for mounting cameras 105 to ribs 103 including, but not limited to clamps and the like.

In yet further cameras 105 can comprise mounting apparatus that mate with complimentary mounting apparatus at mounting rig 101 and/or ribs 103; for example, one of mounting rig 101 (and/or ribs 103), and cameras 105 can comprise respective protrusions and/or rails and the like, and the other of mounting rig 101 (and/or ribs 103) and cameras 105 can comprise complimentary holes and/or apertures and like for receiving the protrusions etc., the protrusions releasably insertable into the holes and/or apertures for mounting cameras 105 to mounting rig 101 and/or ribs 103. Indeed, in some implementations, each protrusion and complimentary hole can cause a camera 105 to be mounted to mounting rig 101 (and/or ribs 103) at a given orientation and/or angle, so that a user mounting cameras 105 to mounting rig 101 (and/or ribs 103) does not have to decide about the mounting angles, and specifically which mounting angles are most likely to capture at least two (and/or at least three) viewing angles of a substantial portion of surface points of a subject. In these implementations, printed indications can be omitted as the holes and/or protrusions on mounting rig 101 (and/or ribs 103) provide similar functionality. It is further assumed in these implementations that each rib 103 has been assembled in a given position.

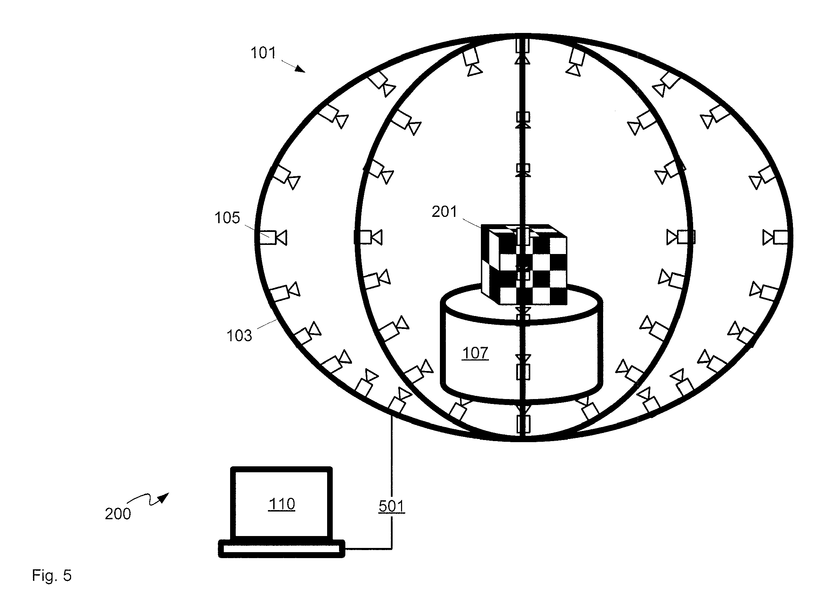

Attention is next directed to Fig. 5 which depicts system 200, and ribs 103, in an assembled state. In these implementations, system 200 comprises: mounting rig 101 comprising plurality of ribs 103 having an assembled state (as depicted in Fig. 5) and an unassembled state (as depicted in Fig 2), plurality of ribs 103 defining a space therein in the assembled state, plurality of ribs 103 being portable in the unassembled state; and plurality of cameras 105 attached to plurality of ribs 103 in the assembled state, plurality of cameras 105 arranged for capturing at least two viewing angles of a substantial portion of surface points of the subject on pedestal 107, other than those portions of the subject that support the subject, including, but not limited to bottoms of feet. Fig. 5 further shows optional pedestal 107 configured to support a subject to be photographed, pedestal 107 located within the space when plurality of ribs 103 are in the assembled state;

Alternatively, system 200 can be described as comprising: mounting rig 101 having an assembled state (as depicted in Fig. 5) and an unassembled state (as depicted in Fig 2), mounting rig 101 defining a space therein in the assembled state, mounting rig 101 being portable in the unassembled state; and plurality of cameras 105 attached to mounting rig 101 in the assembled state, plurality of cameras 105 arranged for capturing at least two viewing angles of a substantial portion of surface points of the subject on pedestal 107, other than those portions of the subject that support the subject, including, but not limited to bottoms of feet.

System 200 further comprises computing device 110 comprising processor 120 and communication interface 124, computing device 115 in communication with each of plurality of cameras 105 using communication interface 124, processor 120 configured to: coordinate plurality of cameras 105 to capture respective image data at substantially the same time; receive a plurality of images comprising the respective image data from plurality of cameras 105; transmit, using communication interface 124, the plurality of images to server 113 for processing into a three dimensional (3D) printer file.

Human and animal subjects generally have more geometric complexity in their lower halves; hence, in order to capture at least two viewing angles of a substantial portion of surface points of the subject located within the defined space, cameras 105 can be arranged so that a density of cameras increases towards a bottom of mounting rig 101, as depicted.

In other words, mounting rig 101 and the arrangement of cameras 105 can allow non-uniform sampling of the viewing sphere (i.e. the space defined by plurality of ribs 103 in the assembled state so that regions where more detail for performing a 3D modelling of a subject is desirable can be more densely sampled.

Fig. 5 further depicts device 110 in communication with cameras 105 via links 501; while only one link 501 to one camera 105 is depicted, it is appreciated that device 110 is in communication with all cameras 105 via a plurality of links 501 and/or a serial link, linking each camera 105 to device 110. Links 501 can be wired and/or wireless as desired.

Fig. 5 further depicts optional pedestal 107 placed within the space defined by mounting rig 101 and/or ribs 103, with optional calibration device 205 placed on pedestal 107. In the absence of pedestal 107, calibration device 205 can be placed on a bottom and/or floor of mounting rig 101 in the assembled state. In general, calibration device 205 can be used in an optional initial calibration process, that can assist in later determining one or more camera parameters at server 113; in the optional calibration process, device 110: controls cameras 105 to capture optional calibration data (and/or calibration image data) comprising images of calibration device 205, and specifically images of the calibration patterns there upon; and transmits, using interface 124, the optional calibration data to server 113 for use by server 113 in generating a 3D printer file, and specifically to assist in determining one or more camera parameters, as described below. Transmission of the optional calibration data can occur when optional calibration data is acquired, and/or when images of a subject are transmitted to server 113. When the calibration process is not implemented, server 113 can alternatively determine one or more camera parameters using images 603.

Before or after the optional calibration process, background images are captured. For example, device 110: control cameras 105 to capture background image data comprising images of the defined space (and/or pedestal 107) without a subject; and transmit, using interface 124, the background image data to server 113 for use by server 113 in generating a 3D printer file. Transmission of the background image data can occur when background image data is acquired, and/or when images of a subject are transmitted to server 113.

The optional calibration process and background image capture process can be performed once for each time system 200 is assembled. The calibration data and background image data can be used for a plurality of subjects. In other words, the optional calibration process and background image capture process can be performed once and used with images for a plurality of subjects.

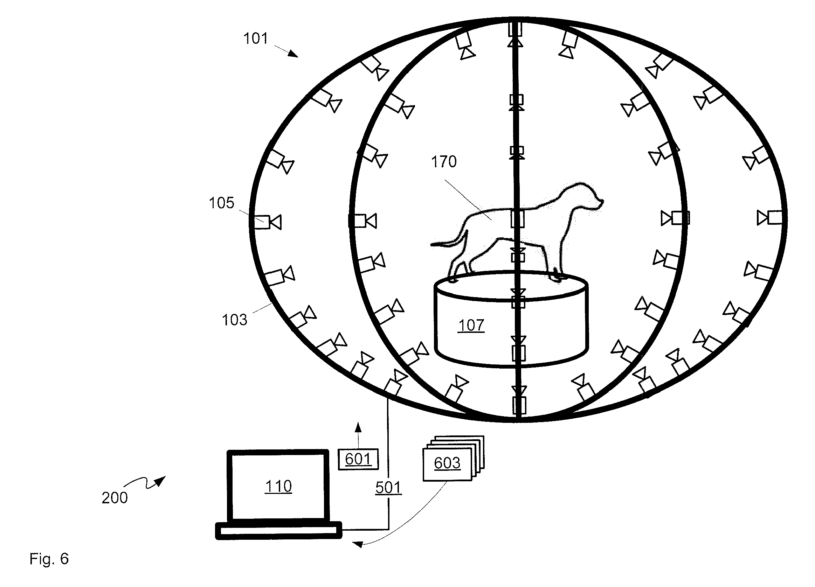

Subject 170 can then be placed and/or positioned within the defined space and/or on pedestal 107 when present, as depicted in Fig. 6, which is substantially similar to Fig. 5 with like elements having like numbers. In some implementations, real-time image feedback can be used to aid an operator in finding a location for subject 170 on 107, using display 126 of computing device 110 or, optionally, making adjustments to the locations of cameras 105 (noting that moving one or more cameras 105 can initiate a repeat of the calibration and background processes).

Once subject 170 is positioned, device 110 controls cameras 105, via link 501 to: coordinate cameras 105 to capture respective image data at substantially the same time, for example by transmitting a triggering signal 601 to camera 105 via links 501; and receive a plurality of images 603 comprising respective image data from the plurality of cameras 105. Triggering signal 601 can control cameras 105 to capture images at substantially the same time and/or cause cameras 105 to operate in a coordinated synchronous mode so that a plurality of images 603 are captured by cameras 105 each time device 110 triggers a signal 601 to capture a set of images. There can be a delay, however between a first shutter actuation and last shutter actuation of cameras 105. In general, a time delay between a first shutter actuation and last shutter actuation of cameras 105 can be less than about 1/20^{th} of a second and/or less than about half a second. In particular non-limiting implementations, a time delay between a first shutter actuation and last shutter actuation of cameras 105 can be less than about 1/100^{th} of a second, to increase the chances of acquiring set of images of the subject when the subject is not moving and/or so that an acquired set of images does not contain blur and/or has an acceptable amount of blurring (which can be defined by a threshold value).

Triggering signal 601 can include a plurality of formats, including, but not limited to; a signal causing each of cameras 105 to acquire a respective image of subject 170; a signal causing each of cameras 105 to periodically acquire respective images of subject 170 (e.g. a coordinated synchronous mode and/or a coordinated burst mode), and the like. In general, images 603 comprise images of subject 170 from a plurality of viewing angles, so that figurine 175 can be later produced, images 603 including at least two viewing angles of a substantial portion of surface points of subject.

Images 603 can be reviewed at display 126 of device 110; when cameras 105 capture more than set of images 603 in a burst mode and/or a coordinated synchronous mode, the different sets of images 603 can be reviewed at display 126 so that a particular set of images 603 can be selected manually. Alternatively, processor 120 can be configured to process the sets of images 603 from cameras 105, using image processing techniques, to determine whether a set of images 603 meets given criteria, for example, blur in images 603 being below a threshold value and/or subject 170 being in a given pose. In other words, animals and/or children can have difficulty keeping still within mounting rig 101, and a set of images 603 can be selected where subject 170 is momentarily still and/or in a desirable pose.

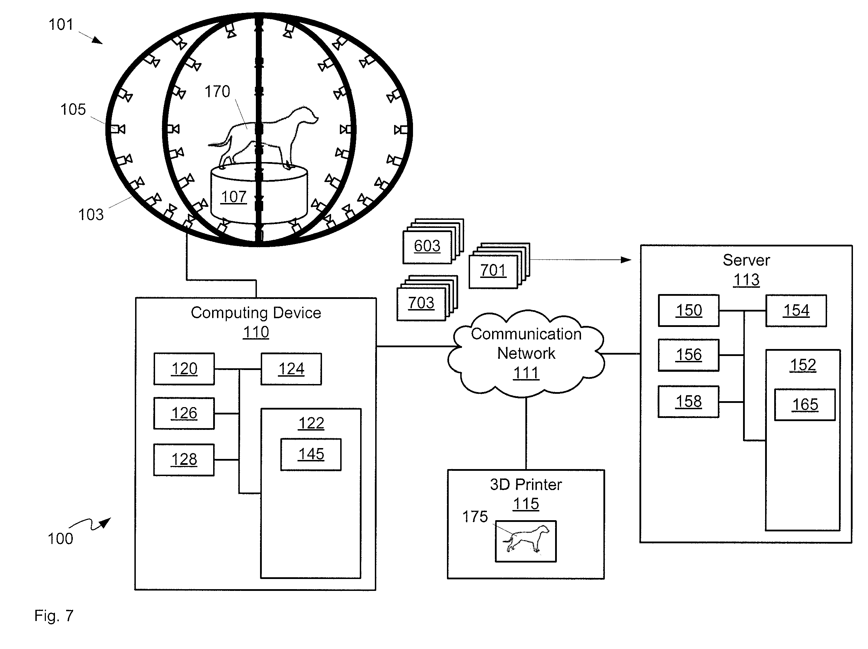

With reference to Fig. 7, which is substantially similar to Fig. 1, with like elements having like numbers, images 603 are then transmitted to server 113 for processing into a 3D printer file as described below. As also depicted in Fig. 7, optional calibration data 701, comprising a plurality of images of calibration device 205, and background image data 703, comprising a plurality of images of the space defined by mounting rig 101 in the assembled state (and/or pedestal 107) without subject 170, are also transmitted to server 113 with images 603. However, in other implementations, optional calibration data 701 and background image data 703 are transmitted independent of images 603; in these implementations, processor 120 is further configured to generate metadata identifying a time period in which images 603 were acquired so that images 603 can be coordinated with one or more of optional calibration data 701 and background image data 703. For example, optional calibration data 701 and background image data 703 can be generated and transmitted to server 113 independent of images 603 and/or each other, and metadata of images 603 can be used to coordinate images 603 with one or more of optional calibration data 701 and background image data 703; for example, the metadata can comprise a date and/or time and/or location that images 603 were acquired and/or transmitted. The metadata can further include a geographic location and/or an address of a user requesting figurine 175 and/or payment information. The metadata can optionally include respective metadata for each image 603 that relates a given image to a specific camera 105; in some implementations, the metadata can include a location of a given camera 105 on mounting rig 101 and/or a location of a given camera 105. Such metadata can also be incorporated into optional calibration data 701 and background image data 703 so that images 603 can be coordinated with optional calibration data 701 and background image data 703.

Furthermore, as described above, optional calibration data 701 and background image data 703 can be used with a plurality of image sets each corresponding to images of different subjects and/or different sets of images of the same subject.

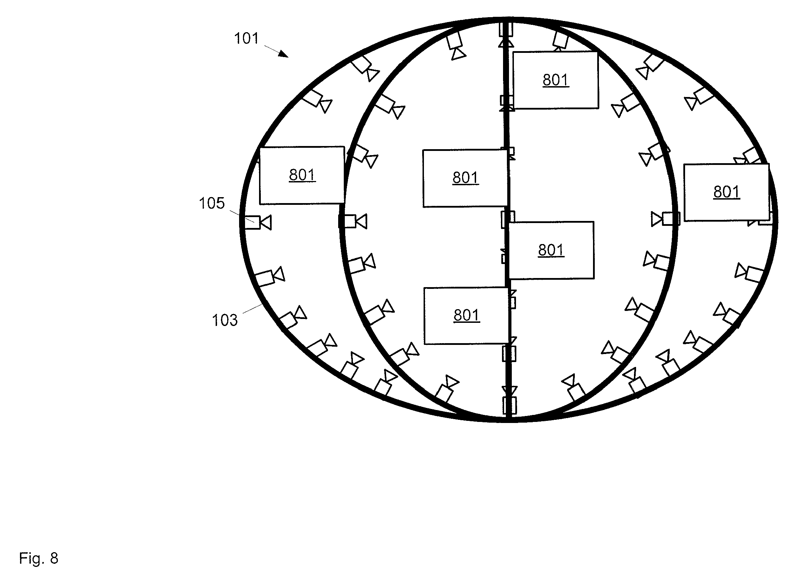

In some implementations, system 200 and/or mounting rig 101 and/or ribs 103 can be modified to incorporate one or more of lighting and background apparatus. For example, attention is directed to Fig. 8, which depicts ribs 103 assembled into mounting rig 101, and cameras 105, as well as indirect panel lights 801 removabley attached to mounting rig 101 and/or ribs 103. Indirect panel lights 801 provide indirect, diffuse, and generally uniform light to light subject 170. Other types of lighting are within the scope of present implementations, including, but not limited to, lighting coordinated with acquisition of images 603. While not depicted, in some implementations, mounting rig 101 and/or ribs 103 can be further modified to include reflectors for reflecting light from lighting onto subject 170.

Attention is next directed to Fig. 8, which depicts ribs 103 assembled into mounting rig 101, and cameras 105, with background objects 901 removabley attached to ribs 103 in the assembled state. As depicted, background objects 901 comprise one or more of background curtains and background flats, which provide a background in images 603, optional calibration data 701 and background image data 703. In some implementations, efficiency and/or computational complexity can be reduced by using background objects 901 of a color that can contrast with subject 170; for example, when subject 170 comprises an animal, at least a portion of background objects that face towards an interior of mounting rig 101 can be of a color that does not generally occur in animals and/or pets, for example greens, blues and the like; however, the color also can be based on the type of subject. For example, when a subject is a bird, such as a parrot, or a lizard, each of which can be green, and/or blue, the color of background objects 901 can be brown to contrast therewith. When the subject is a human, the subject can be informed of the color of background objects 901 and/or asked to wear clothing that contrasts therewith. However, when a color of a subject and the background are of a similar color, local image features, including, but not limited to Local Descriptors, can be used to distinguish there between, as described below. In other words, contrasting color between subject and background can assist in increasing efficiency and/or accuracy of producing a 3D printer file, as described below, but such contrast between a subject and a background is optional.

In some implementations, ribs 103 (and/or optional pedestal 107) can be a similar color as background objects 901; in yet further implementations, system, 200 can further comprise a background object, such as a carpet and the like, of a similar color as background objects which is placed under mounting rig 101.

While not depicted, in yet further implementations, system 200 can be modified to include a frame configured to at least partially encircle mounting rig 101 and/or ribs 103 in the assembled state, and background objects 901, such as curtains, flats and the like, are attachable the frame.

Regardless, background objects 901 generally both provide a background for subject 170 and block out objects surrounding mounting rig 101 so that the background is generally constant; hence, in background image data 703, the background will be similar and/or the same as in images 603. However, such a contrast between subject and background can assist in increasing efficiency and/or accuracy of producing a 3D printer file, as described below, but such contrast between a subject and a background is optional. Hence, background objects 901 are optional.

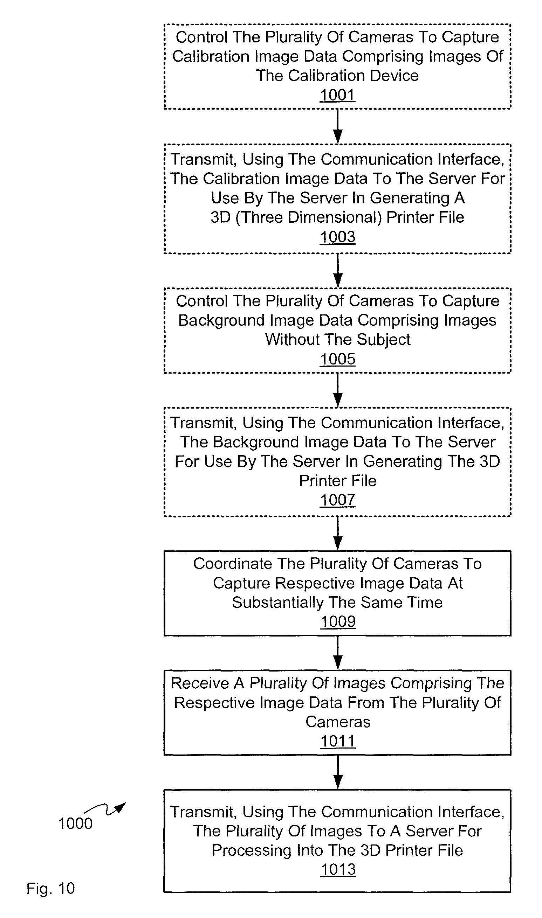

Attention is next directed to Fig. 10 which depicts a flowchart illustrating a method 1000 for acquiring images for producing a 3D figurine, according to non-limiting implementations. In order to assist in the explanation of method 1000, it will be assumed that method 1000 is performed using systems 100, 200. Furthermore, the following discussion of method 1000 will lead to a further understanding of systems 100, 200 and its various components. However, it is to be understood that systems 100, 200 and/or method 1000 can be varied, and need not work exactly as discussed herein in conjunction with each other, and that such variations are within the scope of present implementations. It is appreciated that, in some implementations, method 1000 is implemented in systems 100, 200 by processor 120 of device 110, for example by implementing application 145.

It is to be emphasized, however, that method 1000 need not be performed in the exact sequence as shown, unless otherwise indicated; and likewise various blocks may be performed in parallel rather than in sequence; hence the elements of method 1000 are referred to herein as "blocks" rather than "steps". It is also to be understood that method 1000 can be implemented on variations of systems 100, 200 as well.

At optional block 1001, processor 120 controls cameras 105 to capture optional calibration data 701 comprising images of calibration device 205. At optional block 1003, processor 120 transmits, using interface 124, optional calibration data 701 to server 113 for use by server 113 in generating the 3D printer file. At optional block 1005, processor 120 controls cameras 105 to capture background image data 703 comprising images of the defined space (and/or pedestal 107) without subject 170 (or calibration device 205). At optional block 1007, processor 120 transmits, using interface 124, background image data 703 to server 113 for use by server 113 in generating the three 3D printer file. Blocks 1001 to 1007 are appreciated to be optional as calibration data 701 and/or background image data 703 are optional. For example, while calibration data 701 and/or background image data 703 can assist in increasing efficiency and/or accuracy of producing a 3D printer file, as described below, a 3D printer file can be produced in the absence of calibration data 701 and/or background image data 703.

At block 1009, processor 120 coordinates cameras 105 to capture respective image data at substantially the same time. At block 1011, processor 120 receives images 603 comprising the respective image data from the cameras 105. At block 1013, processor 120 transmits, using interface 124, images 603 to server 113 for processing into the 3D printer file. Blocks 1003, 1005 and 1013 can occur independently and/or in parallel. Similarly blocks 1001, 1005 and 1009 can be performed in any order; in other words, images 603, optional calibration data 701 and/or optional background image data 703 can be acquired in any order. For example optional calibration data 701 and/or optional background image data 703 can be acquired after images 603 and then transmitted to server 113.

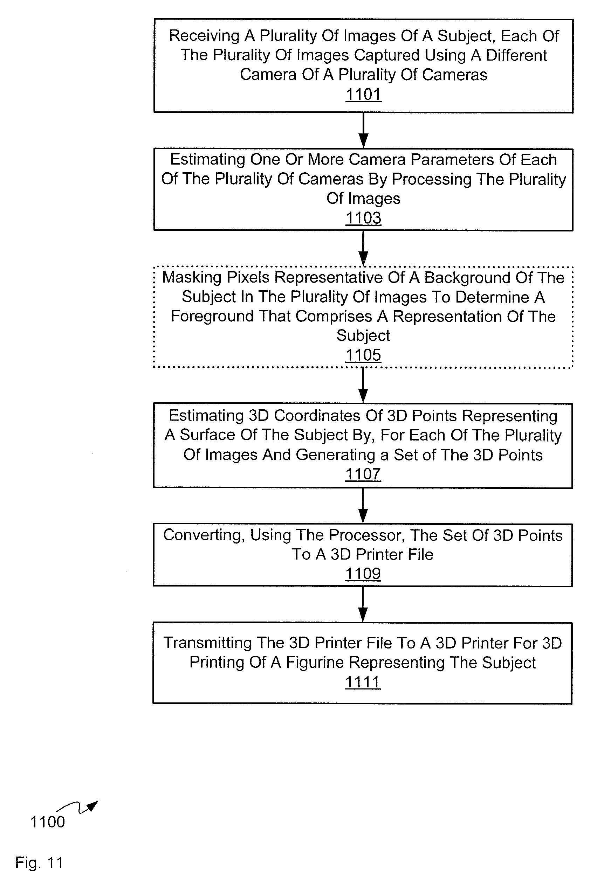

Attention is next directed to Fig. 11 which depicts a flowchart illustrating a method 1100 for producing a 3D printer file, according to non-limiting implementations. In order to assist in the explanation of method 1100, it will be assumed that method 1100 is performed using system 100. Furthermore, the following discussion of method 1100 will lead to a further understanding of system 100 and its various components. However, it is to be understood that systems 100 and/or method 1100 can be varied, and need not work exactly as discussed herein in conjunction with each other, and that such variations are within the scope of present implementations. It is appreciated that, in some implementations, method 1100 is implemented in systems 100 by processor 150 of server 113, for example by implementing application 165.

It is to be emphasized, however, that method 1100 need not be performed in the exact sequence as shown, unless otherwise indicated; and likewise various blocks may be performed in parallel rather than in sequence; hence the elements of method 1100 are referred to herein as "blocks" rather than "steps". It is also to be understood that method 1100 can be implemented on variations of system 100 as well.

At block 1101, processor 120 receives, using communication interface 154, plurality of images 603 of a subject, each of plurality of images 603 captured using a different camera 105 of the plurality of cameras 105.

At block 1103, processor 120 estimates one or more camera parameters of each of plurality of cameras 105 by processing plurality of images 603.

At an optional block 1105, processor 120 masks pixels representative of a background of the subject in plurality of images 603 to determine a foreground that comprises a representation of the subject.

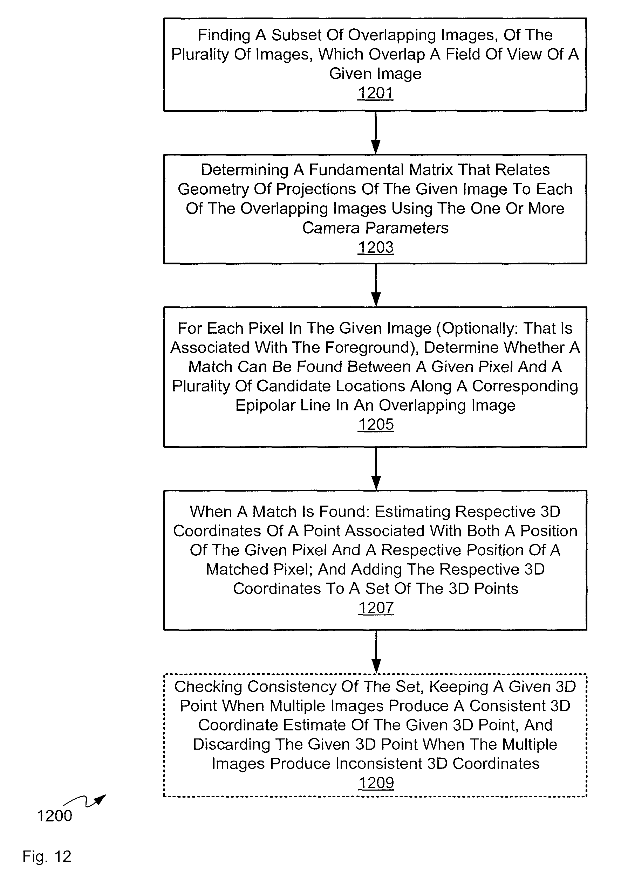

At block 1107, processor 120 estimates 3D coordinates of 3D points representing a surface of the subject, generating a set of the 3D coordinates as described below with reference to Fig 12.

At block 1109, processor 120 converts the set of the 3D points to a 3D printer file.

At block 1111, processor 120 transmits, using communication interface 154, the 3D printer file to 3D printer 115 for 3D printing of a figurine representing the subject.

Method 1100 will now be described in further detail.

As described above, server 113 generally receives images 603 (block 1101), and can optionally receive background image data 703 and/or calibration data 701 before, after and/or in parallel with images 603.

Estimating one or more camera parameters of each of plurality of cameras 105 estimated at block 1103 can include, but is not limited to, using Bundle Adjustment. One or more camera parameters can include, but are not limited to: respective representations of radial distortion for each of cameras 105; an angle and/or orientation of each camera 105; a position of each camera 105; a focal length of each camera 105, a pixel size of each camera 105; a lens aberration of each camera 105, and the like.

In implementations that include optional calibration data 701, estimation of one or more camera parameters can include processing optional calibration data 701 to determine an initial estimate of the one or more camera parameters, for example by using representations of the calibration patterns of calibration device 205 in calibration data 701 to determine the initial estimate. Thereafter, images 603 can be processed using bundle adjustment and the initial estimate to determine a final estimate of the one or more camera parameters. The initial estimate of one or more camera parameters for each camera 105 can be coordinated with further processing of images 603 using metadata in images 603 and metadata in calibration data 701 (e.g. respective metadata relating a given image and/or calibration image to a specific camera 105 and/or identifying a location of a given camera 105) to match images 603 with its corresponding calibration data 701.

In some implementations, the one or more camera parameters can comprise respective representations of radial distortion for each of cameras 105, for example due to lens aberrations; in these implementations, once respective representations of radial distortion for each of cameras 105 are determined, method 1100 can optionally comprise processor 120 correcting one or more types of image distortion in images 603 using the respective representations of the radial distortion; such corrections can occur prior to block 1105 and/or in conjunction with block 1105, and/or in conjunction with block 1103.

Masking the pixels representative of a background of the subject in images 603, to determine the foreground that comprises the representation of the subject, can optionally occur at optional block 1105 by comparing images 603, wherein the subject is present, with background images where the subject is not present and otherwise similar images 603. Hence, for example each image 603 is compared to a corresponding background image in the background image data 703 (e.g. using the respective metadata relating a given image and/or background image to a specific camera 105 and/or identifying a location of a given camera 105 to coordinate), the corresponding background image acquired using the same camera 105 as a given image 603 being compared thereto, to determine which pixels in the given image correspond to the subject and which pixels correspond to the background; the background pixels are masked and/or ignored in the remaining blocks of method 1100.

In other words, at optional block 1105, background images are compared against those images 603 where a subject is present. Pixels in images 603, where the background is visible, are masked-out to prevent processing resources from being allocated to processing out-of-bounds and/or background regions. Regions where features of the subject are present can be referred to as the foreground and/or foreground regions. Such masking can assist in increasing efficiency and/or accuracy of producing a 3D printer file, as described below, however a 3D printer file can be produced in the absence such masking and/or background image data 703.

Estimating 3D coordinates at block 1107 is described with reference to Fig. 12, which depicts a method 1200 of estimating 3D coordinates, according to non-limiting implementations, method 1200 corresponding to block 1107 of method 1100. Furthermore, method 1200 is implemented for each image 603 in plurality of images 603. In other words, processor 120 performs method 1200 for each of images 603.

At block 1201, for a given image 603, processor 120 finds a subset of overlapping images 603, of the plurality of images 603, which overlap a field of view of a given image 603. For example, for a given image 603, which comprises features of a subject, processor 120 determines which of images 603 comprises at least a portion of the same features; such a subset of images 603 comprise images which overlap with the given image. Determination of images that overlap with the given image 603 can occur using image processing techniques to identify common features in images 603 or alternatively, using one or more of the camera parameters estimated at block 1103.

At block 1203, processor 120 determines a Fundamental Matrix that relates geometry of projections of the given image 603 to each of the overlapping images 603 using the one or more camera parameters. For example, when the one or more camera parameters comprises the respective positions and respective orientations of: a camera 105 used to acquire the given image 603; and respective cameras 105 used to acquire the overlapping images 03; determining the Fundamental Matrix comprises using the respective positions and the respective orientations to determine the Fundamental Matrix. In general, in Epipolar geometry, with homogeneous image coordinates, x and x', of corresponding points in a pair of images 603 (i.e. the given image 603 and an overlapping image 603), the Fundamental Matrix describes a line (referred to as an Epipolar Line) on which a corresponding point x' on the other image lies. In other words, for a point x on the given image 603, for example, which corresponds to a feature and/or a pixel of the feature, in the given image 603, the corresponding point x' in the overlapping image 603,which corresponds to the same feature, but from a different angle, lies on the Epipolar line described by the Fundamental Matrix.

At block 1205, for each pixel in the given image 603, processor 120 determines whether a match can be found between a given pixel and a plurality of candidate locations along a corresponding Epipolar line in an overlapping image 603 as determined from the Fundamental Matrix.

In implementations where masking occurs at block 1105 to determine a foreground that comprises a representation of the subject then at block 1205, determining whether a match can be found between a given pixel and a plurality of candidate locations along a corresponding Epipolar line in an overlapping image 603 occurs for each pixel in the given image that is associated with the foreground; the pixels representative of the background are ignored. In other words, in these implementations, for each pixel in the given image 603 that is associated with the foreground, processor 120 determines whether a match can be found between a given pixel and a plurality of candidate locations along a corresponding Epipolar line in an overlapping image 603 as determined from the Fundamental Matrix. Processor 150 ignores those pixels that were masked at block 1105 as they correspond to the background, which generally reduces use of processing resources at server 113. Otherwise, in the absence of masking, processor 150 can use local image features, including, but not limited to, Local Descriptors to distinguish between pixels that correspond to the subject/foreground and pixels that correspond to the background.

At block 1207, when a match is found between a given pixel and the plurality of candidate locations along a corresponding Epipolar line in an overlapping image 603: processor 120 estimates respective 3D coordinates of a point associated with both a position of the given pixel and a respective position of a matched pixel, including, but not limited to triangulation techniques, and the like; furthermore, processor 120 adds the respective 3D coordinates to a set of the 3D points. In general, the set of the 3D points represents a set of points which represent a surface of the subject.

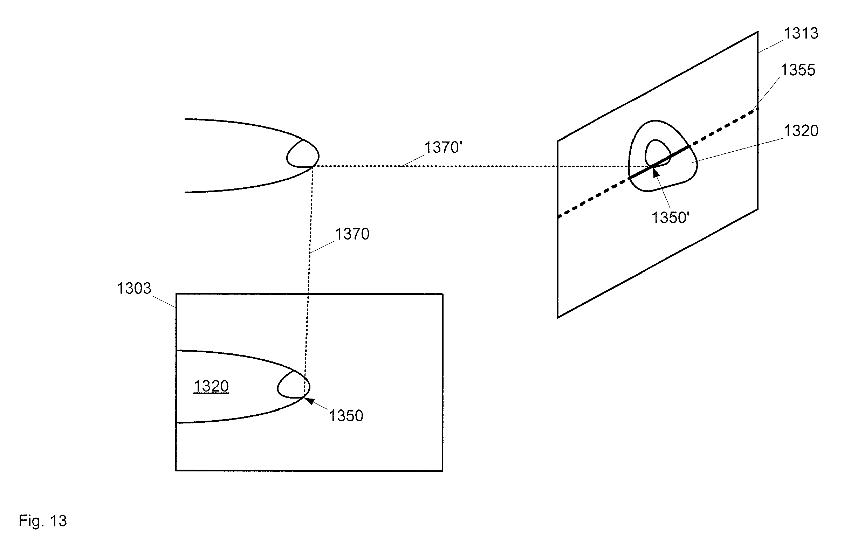

Aspects of method 1200 are generally illustrated in Fig. 13, which depicts a given image 1303 that is being processed by processor 120 using method 1200, and an overlapping image 1313, as determined at block 1201. Each of given image 1303 and overlapping image 1313 comprises a respective image from plurality of images 603.

Further, each of images 1303, 1313 includes at least one similar feature 1320 of a subject, as depicted a snout of a dog, including the nose. Given image 1303 includes a side view of feature 1320 while overlapping image 1313 includes a front view of feature 1320; while each of images 1303, 1313 include different aspects of feature 1320, at least some of the aspects, such as a side of the nose are included in each of images 1303, 1313. In other words, image 1313 overlaps with image 1303.

It is appreciated that when method 1200 is applied to image 1313, image 1303 is designated as an image overlapping with image 1313.

In any event, once overlapping image 1313 is found at block 1201, at block 1203, a Fundamental Matrix is determined between images 1303, 1313. Then, at block 1205, each pixel in given image 1303 (an optionally each pixel in given image 1303 that is associated with the foreground, ignoring pixels associated with the background) is compared to a plurality of candidate locations along a corresponding Epipolar line in overlapping image 1313. For example, when processor 120 is processing a pixel 1350 at a bottom side edge of the nose in feature 1320, the Fundamental Matrix is used to determine the corresponding Epipolar line 1355 in overlapping image 1313. Each pixel along Epipolar line 1355 is then processed to determine whether any of the pixels correspond to pixel 1350, using local image features, including, but not limited to,, Local Descriptors; as depicted, pixel 1350' along Epipolar line 1355 corresponds to pixel 1350, as each depict a pixel corresponding to the same position on feature 1320, but from different angles, as indicated by lines 1370, 1370'. It is further appreciated that pixels along Epipolar line that can be masked and/or correspond to the background, can be ignored; in Fig. 13, portions of Epipolar line 1355 that are part of the background and hence can be masked are stippled, while portions of Epipolar line 1355 that are part of the foreground are solid.

In any event, as processor 120 has determine that a match has occurred, at block 1207, 3D coordinates of a point that corresponds to both of pixels 1350, 1350' are estimated and stored in a set of the 3D points.

At an optional block 1209, processor 120 can check the consistency of the set of the 3D points, keeping a given 3D point when multiple images 603 produce a consistent 3D coordinate estimate of the given 3D point, and discarding the given 3D point when the multiple images 603 produce inconsistent 3D coordinates. For example, the 3D points generally represents a surface of a subject; when one or more of the 3D points is not located on the surface as defined by the other 3D points, and/or discontinuous with the other 3D points, the 3D points not located on the surface are discarded, so that the surface is consistent and/or continuous.

This process is repeated for all pixels in image 1303, and further repeated for all images 603 which overlap with image 1303. Alternatively, the process is repeated for all pixels in image 1303 that correspond to the foreground, and further repeated for all images 603 which overlap with image 1303. Regardless, while Fig. 13 depicts one overlapping image 1313, a plurality of images 603 can overlap with image 1303 and blocks 1203, 1205 and 1207 are repeated for each overlapping image, and further for each of pixels in image 1303 when a different overlapping image is compared therewith. Method 1200 is further repeated for each of images 603 so that every pixel of each image 603 (and/or every pixel in the foreground region of each image 603) is used to estimate a 3D point of a subject's surface geometry. Furthermore, a color of each 3D point can be determined in method 1200, by determining a color associated with each pixel that in turn corresponds to a color of the feature at each pixel.

Hence, the resulting set comprises a full-colour cloud of points, the density of which is dependent on the resolution of cameras 105.

Method 1200 can further be expressed as follows:
Let the set of "n" images 603 be expressed as set I={I₁; I₂;...; Iₙ}. Method 1200 (which can also be referred to as 3D reconstruction algorithm) iterates over each of the images in set I, repeating the following steps for the i^{th} image (Iᵢ):
   1. Find the subset of images Nᵢ where there is any overlapping field of view with the image Iᵢ. This information can be automatically estimated using a convex hull of a 3D Delaunay triangulation of the positions of cameras 105.
   2. Iterate over overlapping images {Iⱼ |j is an element of Nᵢ}:
      (a) Determine the Fundamental Matrix Fᵢⱼ that relates the geometry of projections onto image Iᵢ and that of the image Iⱼ.
      (b) Initialize a Cloud of Points Sᵢ for the i^{th} image as empty.
      (c) Iterate over all of the pixels k in Iᵢ: i. An optional check can occur to verify that k is in the foreground of Iᵢ; ii. Match pixel Iᵢ(k) along its corresponding Epipolar Line on Iⱼ, as in Fig. 13; iii. When a match is found, estimate the 3D coordinates of k (k_{3D}) and add them to a set Sᵢ (Sᵢ = Sᵢ (Sᵢ=Sᵢ ∪ k_{3D}).
   3. Optionally check the consistency of the 3D locations estimated for each pixel k in Iᵢ, keeping 3D points only when multiple images produce similar 3D location estimates.

The consistency check can occur when cameras 105 have captured at least three viewing angles of a substantial portion of a surface of a subject.

Attention is next returned back to method 1100 where, at block 1107, the set of the 3D points is generated which can include co-registering the cloud of points onto a coherent surface S. At block 1109, processor 120 converts the set of the 3D points to a 3D printer file. Block 1109 can include, but is not limited to, transforming the point-cloud S into a 3D surface model; and determining a polygonal relation between the set of the 3D points, and estimating surface normals thereof, for example as occurs in 3D computer visualizations. The 3D printer file that is produced is generally processable by 3D printer 115. In some implementations the entity associated with server 113 can have a relationship with a plurality of entities each operating one or more respective 3D printers; in these implementations, two or more of the 3D printers can have different 3D printer file formats; in these implementations, block 1109 can further comprise determining which 3D printer file format to use, for example based on a database of 3D printer entities, and 3D printer formats corresponding thereto. A specific 3D printer entity can be selected based on a geographic location and/or address of the user that has requested figurine 175 received as metadata with images 603: for example, as system 200, that acquires images 603 is portable, and a plurality of systems 200 can be used to acquire images over a larger geographic area, a 3D printer entity can be selected to reduce shipping charges of figurine 175 to the user. Selection of a 3D printer entity can also be based on latency of printing/shipping of figurine 175; for example, when resources of one 3D printer entity are busy and/or booked for given time period, a different 3D printer entity can be selected. Such selection can occur manually, for example using input device 158 and/or automatically when a computing device associated with entity operating 3D printer 115 transmits latency data to server 113 via network 111.

At block 1111, processor 120 transmits 3D printer file to 3D printer 115. 3D printer 115 receives the 3D printer file and 3D prints figurine 175. Processor 120 can further transmit an address of a user to which figurine 175 is to be shipped, so that the entity operating 3D printer 115 can package and ship figurine 175 to the user.

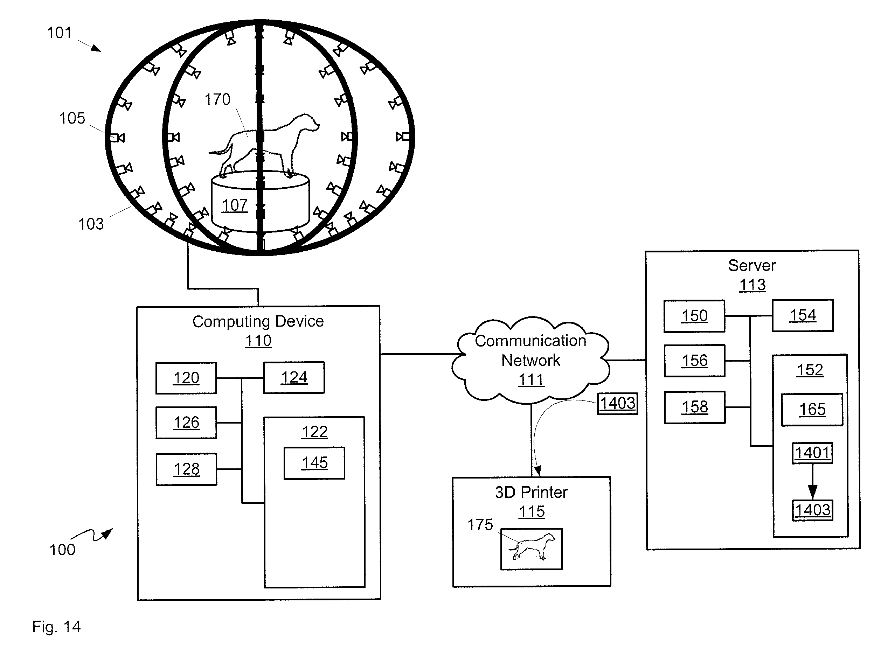

Blocks 1109 and 1111 are further illustrated in Fig. 14, which is substantially similar to Fig. 1, with like elements having like numbers. It is assumed in Fig. 14 that server 1113 has produced a set 1401 of 3D points and stored set 1401 at memory 152. Processor 120 can then generate a 3d printer file 1403 from set 1401, and transmit 3D printer file 1403 to 3D printer 115, where figurine 175 is produced.

Provided herein is a system, apparatus and method, for producing a three dimensional printed figurine including a portable 3D scanning system (that can include software and hardware) that enables moving objects to be "instantaneously" 3D scanned (e.g. within about 1/100^{th} of second and/or within about 0.5 seconds). The system is composed of an array of cameras that are held by a mounting rig. The rig is such that the cameras obtain partially overlapping views from many possible viewing angles. Synchronous release of all camera shutters allows "instantaneous" capture of all images of a subject by the cameras. Epipolar geometry and local image features, including, but not limited to, Local Descriptors, are used to locate and match corresponding points between different images. Estimation of the 3D location of corresponding points can be achieved using triangulation. A dense cloud of 3D points that covers the entire surface of the subject is generated, which comprises a computer 3D representation of such a surface. A reconstruction method can be used to transform the cloud of points representation into a polygonal 3D surface representation, potentially more suitable for 3D display and 3D printing.

Those skilled in the art will appreciate that in some implementations, the functionality of device 110 and server 113 can be implemented using pre-programmed hardware or firmware elements (e.g., application specific integrated circuits (ASICs), electrically erasable programmable read-only memories (EEPROMs), etc.), or other related components. In other implementations, the functionality of device 110 and server 113 can be achieved using a computing apparatus that has access to a code memory (not shown) which stores computer-readable program code for operation of the computing apparatus. The computer-readable program code could be stored on a computer readable storage medium which is fixed, tangible and readable directly by these components, (e.g., removable diskette, CD-ROM, ROM, fixed disk, USB drive). Furthermore, it is appreciated that the computer-readable program can be stored as a computer program product comprising a computer usable medium. Further, a persistent storage device can comprise the computer readable program code. It is yet further appreciated that the computer-readable program code and/or computer usable medium can comprise a non-transitory computer-readable program code and/or non-transitory computer usable medium. Alternatively, the computer-readable program code could be stored remotely but transmittable to these components via a modem or other interface device connected to a network (including, without limitation, the Internet) over a transmission medium. The transmission medium can be either a non-mobile medium (e.g., optical and/or digital and/or analog communications lines) or a mobile medium (e.g., microwave, infrared, free-space optical or other transmission schemes) or a combination thereof.

Further embodiments will now be describes.

A first embodiment of the present invention provides a system comprising:
a mounting rig having an assembled state and an unassembled state, the mounting rig defining a space therein in the assembled state, the mounting rig being portable in the unassembled state;
a plurality of cameras attached to the mounting rig in the assembled state, the plurality of cameras arranged for capturing at least two viewing angles of a substantial portion of surface points of a subject located within the space when the mounting rig is in the assembled state, other than those portions of the subject that support the subject; and,
a computing device comprising a processor and a communication interface, the computing device in communication with each of the plurality of cameras using the communication interface, the processor configured to:
   coordinate the plurality of cameras to capture respective image data at substantially a same time;
   receive a plurality of images comprising the respective image data from the plurality of cameras; and,
   transmit, using the communication interface, the plurality of images to a server for processing into a three dimensional (3D) printer file.

A second embodiment of the present invention provides the system of the first embodiment, wherein the mounting rig comprises a plurality of ribs that are assembled in the assembled state of the mounting rig, and unassembled in the unassembled state of the mounting rig.

A third embodiment of the present invention provides the system of the first embodiment, further comprising a pedestal configured to support the subject, the pedestal located within the space when the mounting rig is in the assembled state.

A fourth embodiment of the present invention provides the system of the first embodiment, further comprising a calibration device that can be placed within the space prior to capturing images of the subject, the calibration device comprising calibration patterns that can be captured by the plurality of cameras, the processor further configured to:
control the plurality of cameras to capture calibration data comprising images of the calibration device; and
transmit, using the communication interface, the calibration data to the server for use by the server in generating the 3D printer file.

A fifth embodiment of the present invention provides the system of the fourth embodiment, wherein the calibration device comprises one or more of a cube, a hexahedron, a parallelepiped, a cuboid and a rhombohedron, and a three-dimensional solid object, each face of the calibration device comprising a different calibration pattern.

A sixth embodiment of the present invention provides the system of the first embodiment, wherein the processor is further configured to:
control the plurality of cameras to capture background image data comprising images of the space without the subject; and
transmit, using the communication interface, the background image data to the server for use by the server in generating the 3D printer file.

A seventh embodiment of the present invention provides the system of the first embodiment, wherein the processor is further configured to generate metadata identifying a time period in which the respective images were acquired so that the respective images can be coordinated with one or more of calibration data and background data.

An eighth embodiment of the present invention provides the system of the first embodiment, further comprising one or more of background objects, background curtains and background flats.

A ninth embodiment of the present invention provides the system of the eighth embodiment, wherein the background objects are attachable to the mounting rig in the assembled state.

A tenth embodiment of the present invention provides the system of the eighth, further comprising a frame configured to at least partially encircle the mounting rig in the assembled state, wherein the background objects are attachable the frame.

An eleventh embodiment of the present invention provides the system of the first embodiment, wherein the plurality of cameras attached to the mounting rig in the assembled state are arranged to capture at least three viewing angles of the substantial portion of surface points of a subject located within the space when the mounting rig is in the assembled state, other than those portions of the subject that support the subject.

A twelfth embodiment of the present invention provides the system of the first embodiment further comprises one or more of fasteners and tools for assembling the mounting rig to the assembled state from the unassembled state.

A thirteenth embodiment of the present invention a method comprising:
a server comprising a processor and a communication interface, receiving, using the communication interface, a plurality of images of a subject, each of the plurality of images captured using a different camera of a plurality of cameras;
estimating, using the processor, one or more camera parameters of each of the plurality of cameras by processing the plurality of images;
estimating, using the processor, three-dimensional (3D) coordinates of 3D points representing a surface of the subject by, for each of the plurality of images:
   finding a subset of overlapping images, of the plurality of images, which overlap a field of view of a given image;
   determining a Fundamental Matrix that relates geometry of projections of the given image to each of the overlapping images using the one or more camera parameters;
   for each pixel in the given image, determining whether a match can be found between a given pixel and a plurality of candidate locations along a corresponding Epipolar line in an overlapping image and, when a match is found: estimating respective 3D coordinates of a point associated with both a position of the given pixel and a respective position of a matched pixel; and adding the respective 3D coordinates to a set of the 3D points;
converting, using the processor, the set of the 3D points to a 3D printer file; and,
transmitting, using the communication interface, the 3D printer file to a 3D printer for 3D printing of a figurine representing the subject.

A fourteenth embodiment of the present invention provides the method of the thirteenth embodiment, further comprising: masking, using the processor, pixels representative of a background of the subject in the plurality of images to determine a foreground that comprises a representation of the subject; and, when the masking occurs, then the determining whether a match can be found between a given pixel and a plurality of candidate locations along a corresponding Epipolar line in an overlapping image occurs for each pixel in the given image that is associated with the foreground, and the pixels representative of the background are ignored.

A fifteenth embodiment of the present invention provides the method of the thirteenth embodiment, wherein the estimating of the one or more camera parameters of each of the plurality of cameras by processing the plurality of images occurs using Bundle Adjustment.

A sixteenth embodiment of the present invention provides the method of the thirteenth embodiment, therein the camera parameters comprise respective representations of radial distortion for each of the plurality of cameras, the method further comprising correcting, using the processor, one or more types of image distortion in the plurality of images using the respective representations of the radial distortion, prior to the masking.

A seventeenth embodiment of the present invention provides the method of the thirteenth embodiment, wherein the one more camera parameters comprise the respective positions and respective orientations of: a camera used to acquire the given image; and respective cameras used to acquire the overlapping images; the determining the Fundamental Matrix comprising using the respective positions and the respective orientations to determine the Fundamental Matrix.

A eighteenth embodiment of the present invention provides the method of the thirteenth embodiment, further comprising: checking consistency of the set, keeping a given 3D point when multiple images produce a consistent 3D coordinate estimate of the given 3D point, and discarding the given 3D point when the multiple images produce inconsistent 3D coordinates.

An nineteenth embodiment of the present invention provides the method of the thirteenth embodiment, wherein the converting the set of the 3D points to a 3D printer file comprises: determining a polygonal relation between the set of the 3D points; and estimating surface normals thereof.

A twentieth embodiment of the present invention provides a server comprising:
a processor and a communication interface, the processor configured to:
   receive a plurality of images of a subject, each of the plurality of images captured using a different camera of a plurality of cameras;
   estimate one or more camera parameters of each of the plurality of cameras by processing the plurality of images;
   estimate three-dimensional (3D) coordinates of 3D points representing a surface of the subject by, for each of the plurality of images:
      finding a subset of overlapping images, of the plurality of images, which overlap a field of view of a given image;
      determining a Fundamental Matrix that relates geometry of projections of the given image to each of the overlapping images using the one or more camera parameters;
      for each pixel in the given image, determine whether a match can be found between a given pixel and a plurality of candidate locations along a corresponding Epipolar line in an overlapping image and, when a match is found: estimating respective 3D coordinates of a point associated with both a position of a given pixel and a respective position of a matched pixel; and adding the respective 3D coordinates to a set of the 3D points;
convert the set of the 3D points to a 3D printer file; and,
transmit the 3D printer file to a 3D printer for 3D printing of a figurine representing the subject.

Persons skilled in the art will appreciate that there are yet more alternative implementations and modifications possible, and that the above examples are only illustrations of one or more implementations. The scope, therefore, is only to be limited by the claims appended hereto.

## Claims

1. A method comprising:
at a server (113) comprising a processor (150) and a communication interface (154), receiving (1101), using the communication interface (154), a plurality of images of a subject, each of the plurality of images captured using a different camera of a plurality of cameras;
estimating (1103), using the processor (150), one or more camera parameters of each of the plurality of cameras by processing the plurality of images;
estimating (1107), using the processor (150), three-dimensional (3D) coordinates of 3D points representing a surface of the subject by, for each of the plurality of images:
finding (1201) a subset of overlapping images, of the plurality of images, which overlap a field of view of a given image;
determining (1203) a Fundamental Matrix that relates geometry of projections of the given image to each of the overlapping images using the one or more camera parameters; and,
for each pixel in the given image, determining (1205) whether a match can be found between a given pixel and a plurality of candidate locations along a corresponding Epipolar line in an overlapping image and, when a match is found: estimating (1207) respective 3D coordinates of a point associated with both a position of the given pixel and a respective position of a matched pixel; and adding the respective 3D coordinates to a set of the 3D points;
converting (1109), using the processor (150), the set of the 3D points to a 3D printer file; and,
transmitting (1111), using the communication interface (154), the 3D printer file to a 3D printer for 3D printing of a figurine representing the subject.

2. The method of claim 1, further comprising: masking, using the processor (150), pixels representative of a background of the subject in the plurality of images to determine a foreground that comprises a representation of the subject; and, when the masking occurs, then the determining whether a match can be found between a given pixel and a plurality of candidate locations along a corresponding Epipolar line in an overlapping image occurs for each pixel in the given image that is associated with the foreground, and the pixels representative of the background are ignored.

3. The method of any of claims 1 to 2, wherein the estimating of the one or more camera parameters of each of the plurality of cameras occurs by processing the plurality of images occurs using Bundle Adjustment.

4. The method of any of claims 1 to 3, wherein the camera parameters comprise respective representations of radial distortion for each of the plurality of cameras, the method further comprising correcting, using the processor (150), one or more types of image distortion in the plurality of images using the respective representations of the radial distortion, prior to the masking.

5. The method of any of claims 1 to 4, wherein the one more camera parameters comprise the respective positions and respective orientations of: a camera used to acquire the given image; and respective cameras used to acquire the overlapping images; the determining the Fundamental Matrix comprising using the respective positions and the respective orientations to determine the Fundamental Matrix.

6. The method of claim 1, further comprising: checking consistency of the set, keeping a given 3D point when multiple images produce a consistent 3D coordinate estimate of the given 3D point, and discarding the given 3D point when the multiple images produce inconsistent 3D coordinates.

7. The method of any of claims 1 to 5, wherein the converting the set of the 3D points to a 3D printer file comprises: determining a polygonal relation between the set of the 3D points; and estimating surface normals thereof.

8. A server (113) comprising:
a processor (150) and a communication interface (154), the processor (150) configured to:
receive (1101) a plurality of images of a subject, each of the plurality of images captured using a different camera of a plurality of cameras;
estimate (1103) one or more camera parameters of each of the plurality of cameras by processing the plurality of images;
estimate (1107) three-dimensional (3D) coordinates of 3D points representing a surface of the subject by, for each of the plurality of images:
finding (1201) a subset of overlapping images, of the plurality of images, which overlap a field of view of a given image;
determining (1203) a Fundamental Matrix that relates geometry of projections of the given image to each of the overlapping images using the one or more camera parameters; and,
for each pixel in the given image, determine (12015 whether a match can be found between a given pixel and a plurality of candidate locations along a corresponding Epipolar line in an overlapping image and, when a match is found: estimating (1207) respective 3D coordinates of a point associated with both a position of a given pixel and a respective position of a matched pixel; and adding the respective 3D coordinates to a set of the 3D points;
convert (1109) the set of the 3D points to a 3D printer file; and,
transmit (1111) the 3D printer file to a 3D printer for 3D printing of a figurine representing the subject.

9. The server (113) of claim 8, wherein the processor (150) is further configured to:
mask pixels representative of a background of the subject in the plurality of images to determine a foreground that comprises a representation of the subject; and, when the masking occurs, then determine whether a match can be found between a given pixel and a plurality of candidate locations along a corresponding Epipolar line in an overlapping image for each pixel in the given image that is associated with the foreground, and the pixels representative of the background are ignored.

10. The server (113) of any of claims 8 to 9, wherein the processor (150) is further configured to estimate the one or more camera parameters of each of the plurality of cameras by processing the plurality of images occurs using Bundle Adjustment.

11. The server (113) of any of claims 8 to 10, wherein the camera parameters comprise respective representations of radial distortion for each of the plurality of cameras, the processor (150) further configured to correct one or more types of image distortion in the plurality of images using the respective representations of the radial distortion, prior to the masking.

12. The server (113) of any of claims 8 to 11, wherein the one more camera parameters comprise the respective positions and respective orientations of: a camera used to acquire the given image; and respective cameras used to acquire the overlapping images; the processor (150) further configured to determine the Fundamental Matrix by using the respective positions and the respective orientations to determine the Fundamental Matrix.

13. The server (113) of any of claims 8 to 12, wherein the processor (150) is further configured to: check consistency of the set, keep a given 3D point when multiple images produce a consistent 3D coordinate estimate of the given 3D point, and discard the given 3D point when the multiple images produce inconsistent 3D coordinates.

14. The server (113) of any of claims 8 to 13, wherein the processor (150) is further configured to convert the set of the 3D points to a 3D printer file by: determining a polygonal relation between the set of the 3D points; and estimating surface normals thereof.

15. A computer-readable medium storing a computer program, wherein execution of the computer program is for:
at a server (113) comprising a processor (150) and a communication interface (154), receiving (1101), using the communication interface (154), a plurality of images of a subject, each of the plurality of images captured using a different camera of a plurality of cameras;
estimating (1103), using the processor (150), one or more camera parameters of each of the plurality of cameras by processing the plurality of images;
estimating (1107), using the processor (150), three-dimensional (3D) coordinates of 3D points representing a surface of the subject by, for each of the plurality of images:
finding (1201) a subset of overlapping images, of the plurality of images, which overlap a field of view of a given image;
determining (1203) a Fundamental Matrix that relates geometry of projections of the given image to each of the overlapping images using the one or more camera parameters; and,
for each pixel in the given image, determining (1205) whether a match can be found between a given pixel and a plurality of candidate locations along a corresponding Epipolar line in an overlapping image and, when a match is found: estimating (1207) respective 3D coordinates of a point associated with both a position of the given pixel and a respective position of a matched pixel; and adding the respective 3D coordinates to a set of the 3D points;
converting (1109), using the processor (150), the set of the 3D points to a 3D printer file; and,
transmitting (1111), using the communication interface (154), the 3D printer file to a 3D printer for 3D printing of a figurine representing the subject..
